(19) Europäisches Patentamt
European Patent Office
Office européen des brevets

(11) **EP 4 424 998 B1**

(12) **EUROPEAN PATENT SPECIFICATION**

(45) Date of publication and mention
of the grant of the patent:
**12.11.2025 Bulletin 2025/46**

(21) Application number: **22957659.0**

(22) Date of filing: **06.09.2022**

(51) International Patent Classification (IPC):
**F04D 27/00** (2006.01)   **G06F 1/20** (2006.01)
**H05K 7/20** (2006.01)   **F04D 25/16** (2006.01)
**F04D 29/58** (2006.01)

(52) Cooperative Patent Classification (CPC):
**G06F 1/20; F04D 25/166; F04D 27/001;
F04D 27/004; F04D 29/582; G06F 1/206;
H05K 7/20209; H05K 7/20836;** F05D 2260/81;
F05D 2270/303; F05D 2270/3032

(86) International application number:
**PCT/CN2022/117268**

(87) International publication number:
**WO 2024/050685 (14.03.2024 Gazette 2024/11)**

(54) **ROTATION SPEED CONTROL METHOD AND APPARATUS FOR FAN**

VERFAHREN UND VORRICHTUNG ZUR STEUERUNG DER DREHZAHL EINES LÜFTERS

PROCÉDÉ ET APPAREIL DE COMMANDE DE VITESSE DE ROTATION POUR VENTILATEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.09.2024 Bulletin 2024/36**

(73) Proprietor: **NEW H3C AI TECHNOLOGIES CO.,
LTD.**
**Hangzhou, Zhejiang 311258 (CN)**

(72) Inventors:
• **WANG, Minghui**
**Beijing 100102 (CN)**
• **YE, Ting**
**Beijing 100102 (CN)**
• **LIU, Quanbo**
**Beijing 100102 (CN)**
• **LI, Yi**
**Beijing 100102 (CN)**

• **MA, Guosong**
**Beijing 100102 (CN)**
• **ZHAO, Suxia**
**Beijing 100102 (CN)**
• **ZHANG, Yang**
**Beijing 100102 (CN)**

(74) Representative: **Grünecker Patent- und
Rechtsanwälte
PartG mbB
Leopoldstraße 4
80802 München (DE)**

(56) References cited:
CN-A- 101 614 217     CN-A- 104 236 000
CN-A- 105 822 580     CN-A- 114 667 034
CN-A- 114 810 857     CN-A- 114 837 977
CN-A- 114 876 840     CN-A- 114 922 842
GB-D0- 201 308 640    JP-A- 2010 110 185
US-A1- 2014 153 184   US-A1- 2022 252 078

## Description

## TECHNICAL FIELD

The present disclosure relates to the field of communication technologies, and in particular to a method and an apparatus for controlling a rotation speed of a fan and a device.

## BACKGROUND

A network device (e.g. a router and a switch etc.) may include a plurality of boards (e.g. master control board, interface board, service board and the like). During operation process of these boards, different boards have greatly different power consumptions. For example, the power consumption of the boards may be only 100W or more than 600W. When the plurality of boards work with a large power consumption, the network device may have a very high temperature, and thus may easily fail.

In order to cool down the network device, a plurality of fans may usually be deployed in the network device. If the fans rotate at a higher speed, the network device can be cooled down more effectively; if the fans rotate at a lower speed, the network device can be cooled down less effectively. When the fans rotate at a higher speed, the fans may produce larger noise and consume more power, leading to energy wastes. When the fans rotate at a lower speed, the fans may produce smaller noise and consume less power, reducing energy wastes.

To sum up, it can be seen that, when the fans rotate at a higher speed, the network device can be cooled down more effectively, but the fans may produce larger noise and consume more power. In contrast, when the fans rotate at a lower speed, the network device will be cooled down less effectively, but the fans may produce smaller noise and consume less power. Therefore, it is necessary to control a rotation speed of the fans to ensure the fans produce smaller noise and consume less power while avoiding excessively-high temperature of the network device, thereby achieving the purpose of energy saving and noise reduction.

However, in the prior arts, there is still no effective implementation for controlling a rotation speed of the fans to ensure the fans produce smaller noise and consume less power while avoiding excessively-high temperature of the network device.

US 2022/252078 Al discloses a fan system and a fan driving method. The fan system includes a first fan and a second fan, which are used to operate according to a first driving signal and a second driving signal, respectively, and to generate a first rotating speed signal and a second rotating speed signal.

## SUMMARY

It is therefore the object of the present invention to provide an improved method for controlling a rotation speed of a fan, applied to a network device, a corresponding apparatus and a machine readable storage medium that stores machine executable instructions that, when executed, perform a corresponding method.

This object is solved by the subject matter of the independent claims 1, 10 and

Preferred embodiments are defined by the dependent claims.

The present disclosure provides a method for controlling a rotation speed of a fan, which is applied to a network device. The network device includes a plurality of fans. When the network device is in a to-be-adjusted state, the method includes:

determining an initial fan duty cycle currently used by each fan;

based on a target sequence of the plurality of fans, sequentially traversing out each fan as a candidate fan;

performing multiple adjustments on the initial fan duty cycle corresponding to the candidate fan to obtain multiple different candidate fan duty cycles; for each candidate fan duty cycle, obtaining reward data of the network device under the candidate fan duty cycle, and based on the reward data, determining a reward parameter value corresponding to the candidate fan duty cycle; selecting an optimal reward parameter value from the reward parameter values corresponding to the multiple candidate fan duty cycles, and determining the candidate fan duty cycle corresponding to the optimal reward parameter value as a target fan duty cycle corresponding to the candidate fan;

after the target fan duty cycle corresponding to each fan is obtained, if the network device is in a stable state, based on the rotation speed corresponding to the target fan duty cycle corresponding to each fan, controlling the fan.

The present disclosure provides an apparatus for controlling a rotation speed of a fan, which is applied to a network device. The network device includes a plurality of fans. When the network device is in a to-be-adjusted state, the apparatus includes:

a determining module, configured to determine an initial fan duty cycle currently used by each fan;

a processing module, configured to, based on a target sequence of the plurality of fans, sequentially traverse out each fan as a candidate fan; perform multiple adjustments on the initial fan duty cycle corresponding to the candidate fan to obtain multiple different candidate fan duty cycles; for each candidate fan duty cycle, obtain reward data of the network device under the candidate fan duty cycle, and based on the reward data, determine a reward parameter value corresponding to the candidate fan duty cycle; select an optimal reward parameter value from the reward parameter values corresponding to the multiple candidate fan duty cycles, and determine the candidate fan duty cycle corresponding to the optimal reward parameter value as a target fan duty cycle corresponding to the candidate fan;
a controlling module, configured to, after the target fan duty cycle corresponding to each fan is obtained, if the network device is in a stable state, based on the rotation speed corresponding to the target fan duty cycle corresponding to each fan, control the fan.

The present disclosure a machine readable storage medium, where the machine readable storage medium stores machine executable instructions executable by a processor; the processor is configured to execute the machine executable instructions to perform the above method for controlling a rotation speed of a fan.

It can be seen from the above technical solutions that in the embodiments of the present disclosure, multiple adjustments are performed on the initial fan duty cycle of the fans to obtain multiple different candidate fan duty cycles; an optimal reward parameter value is selected from the reward parameter values corresponding to the multiple candidate fan duty cycles, and a candidate fan duty cycle corresponding to the optimal reward parameter value is determined as a target fan duty cycle corresponding to the fans so as to obtain the target fan duty cycle corresponding to each fan. Based on the target fan duty cycle corresponding to each fan, a rotation speed of the fan is determined. In this way, the rotation speed of each fan can be effectively controlled to reduce the power consumption and the noise of the fan. Thus, it can be guaranteed that the fans produce smaller noise, and consume less power while avoiding excessively-high temperature of the network device, thereby achieving the purpose of energy saving and noise reduction. Hence, the requirements of the network device for energy saving and noise reduction can be satisfied, and both noise pollution and inhaling of harmful substances such as dusts in the air can be diminished, helping reduce corrosion to the network device.

**BRIEF DESCRIPTION OF THE DRAWINGS**

To describe the technical solutions in an embodiment of the present disclosure or in the prior art more clearly, drawings required in descriptions of the embodiments of the present disclosure or the prior art will be briefly introduced below. It is apparent that the drawings described below are merely embodiments of the present disclosure and other drawings may be obtained by those of ordinary skill in the prior art based on these drawings in the embodiments of the present disclosure.

FIG. 1 is a flowchart illustrating a method for controlling a rotation speed of a fan according to an embodiment of the present disclosure.
FIG. 2 is a schematic diagram of controlling a rotation speed of a fan according to an embodiment of the present disclosure.
FIG. 3 is a schematic diagram illustrating a Deep Deterministic Policy Gradient (DDPG) algorithm model according to an embodiment of the present disclosure.
FIG. 4 is a structural schematic diagram illustrating an apparatus for controlling a rotation speed of a fan according to an embodiment of the present disclosure.
FIG. 5 is a hardware structure diagram of a network device according to an embodiment of the present disclosure.

**DETAILED DESCRIPTION OF THE EMBODIMENTS**

The terms used in the embodiments of the present disclosure are for the purpose of describing particular examples only, and is not intended to be limiting of the present disclosure. The singular forms such as "a", 'said", and "the" used in the present disclosure and the appended claims are also intended to include multiple, unless the context clearly indicates otherwise. It is also to be understood that the term "and/or" as used herein refers to and includes any or all possible combinations of one or more associated listed items.

It is to be understood that although different information may be described using the terms such as first, second, third, etc. in the present disclosure, these information should not be limited to these terms. These terms are used only to distinguish the same type of information from each other. For example, without departing from the scope of the present disclosure, the first information may also be referred to as the second information and similarly, the second information may also be referred to as the first information. Depending on the context, the word "if" as used herein may be interpreted as "when" or "as" or "in response to determining".

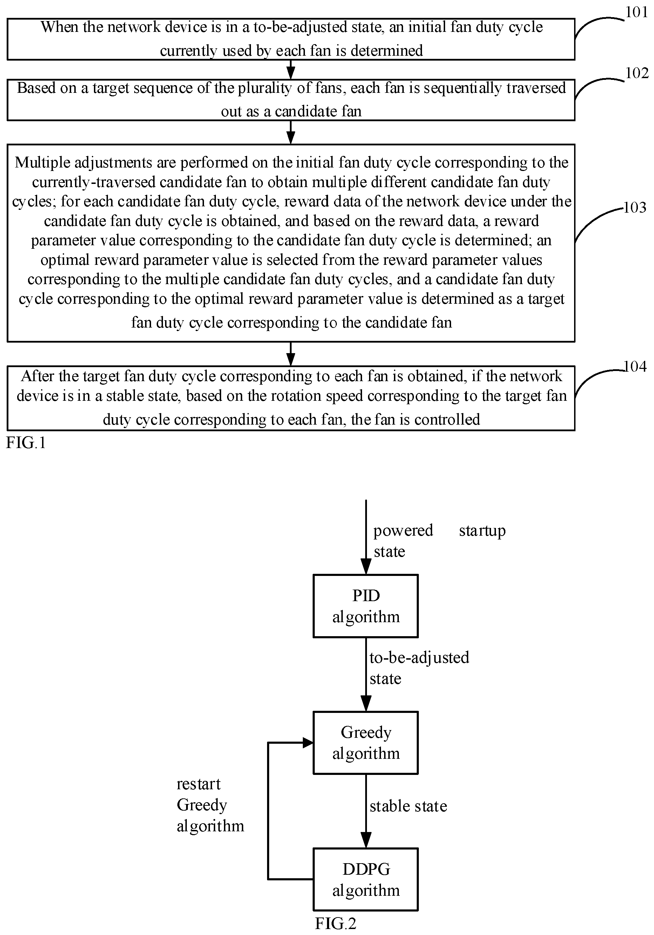

An embodiment of the present disclosure provides a method for controlling a rotation speed of a fan, which is applied to a network device (e.g. a router and a switch and the like). The network device may include a plurality of fans. FIG. 1 is a flowchart illustrating a method for controlling a rotation speed of the fans. The method may include the following steps.

At step 101, when the network device is in a to-be-adjusted state, an initial fan duty cycle currently used by each fan is determined. For example, if a fan is being controlled based on a rotation speed corresponding to a certain fan duty cycle at a current time, the fan duty cycle may be determined as an initial fan duty cycle currently used by the fan.

At step 102, based on a target sequence of the plurality of fans, each fan is sequentially traversed out as a candidate fan.

At step 103, multiple adjustments are performed on the initial fan duty cycle corresponding to the currently-traversed candidate fan to obtain multiple different candidate fan duty cycles; for each candidate fan duty cycle, reward data of the network device under the candidate fan duty cycle is obtained, and based on the reward data, a reward parameter value corresponding to the candidate fan duty cycle is determined; an optimal reward parameter value is selected from the reward parameter values corresponding to the multiple candidate fan duty cycles, and a candidate fan duty cycle corresponding to the optimal reward parameter value is determined as a target fan duty cycle corresponding to the candidate fan.

In an example, based on the reward data, determining the reward parameter value corresponding to the candidate fan duty cycle may include but not limited to: based on the reward data, determining a total system power and a fan duty cycle maximum value; where the reward data includes the fan duty cycle corresponding to each fan, and the fan duty cycle maximum value is a maximum value of all the fan duty cycles; if the reward data includes a power of an electrical source, determining the total system power based on the power of the electrical source; and if the reward data includes a power corresponding to each board and a power corresponding to each fan, determining the total system power based on the powers corresponding to all the boards and the powers corresponding to all the fans; next, based on the fan duty cycle maximum value, determining a target noise value, and based on the total system power and a first weight coefficient corresponding to the total system power, the target noise value and a second weight coefficient corresponding to the target noise value, determining the reward parameter value.

In an example, a sum of the first weight coefficient and the second weight coefficient may be a fixed value (e.g. 1). If energy saving is more important than noise reduction, the first weight coefficient may be greater than the second weight coefficient; if the noise reduction is more important than the energy saving, the first weight coefficient may be smaller than the second weight coefficient.

At step 104, after the target fan duty cycle corresponding to each fan is obtained, if the network device is in a stable state, based on the rotation speed corresponding to the target fan duty cycle corresponding to each fan, the fan is controlled.

In a possible implementation, after the target fan duty cycle corresponding to each fan is obtained, if the network device is still in a to-be-adjusted state, the initial fan duty cycle corresponding to each fan is updated with the target fan duty cycle of the corresponding fan, and the operation of, based on the target sequence of the plurality of fans, sequentially traversing out each fan as a candidate fan is repeated, namely, the step 102 is repeated. When the step 102 is repeated, the target sequence of the plurality of fans may change or may not change.

In an example, if a total number of the fans satisfying target conditions is not less than a preset threshold (the preset threshold may be set based on experiences, for example, set to all fans * a%, where a is 100, or 90 or the like), it is determined that the network device is in a stable state. If the total number of the fans satisfying target conditions is less than the preset threshold, it is determined that the network device is in a to-be-adjusted state. For each fan, if the target fan duty cycle corresponding to the fan is identical to the initial fan duty cycle corresponding to the fan, the fan satisfies the target conditions (i.e., indicating the fan has been adjusted to a local optimal state). Otherwise, if the target fan duty cycle corresponding to the fan is not identical to the initial fan duty cycle corresponding to the fan, the fan does not satisfy the target conditions.

In a possible implementation, after the network device is powered on for startup or the network device gives out a temperature alarm, based on a temperature value of each board of the network device, a to-be-adjusted fan duty cycle corresponding to each fan is determined, where, when the fan is controlled based on the rotation speed corresponding to the to-be-adjusted fan duty cycle corresponding to each fan, it is enabled that an absolute value of a difference between the temperature value of each board and a target temperature value is less than a temperature threshold. After the absolute value of the difference between the temperature value of each board and the target temperature value is larger than the temperature threshold, it can be determined that the network device is in a to-be-adjusted state, and the initial fan duty cycle corresponding to each fan is updated with the to-be-adjusted fan duty cycle corresponding to the fan, and based on the rotation speed corresponding to the initial fan duty cycle corresponding to each fan, the fan is controlled.

In a possible implementation, after the network device is in a stable state, detected state data corresponding to the network device may be obtained, and then input to a trained target action model to obtain an output fan duty cycle corresponding to each fan; where different fans correspond to different output fan duty cycles or a same output fan duty cycle. Based on the reward data of the network device under the output fan duty cycle corresponding to each fan, a first reward parameter value corresponding to the output fan duty cycles is determined; based on the reward data of the network device under the target fan duty cycle corresponding to each fan, a second reward parameter value corresponding to the target fan duty cycles is determined. If the first reward parameter value is superior to the second reward parameter value, it is determined that the network device is in a to-be-adjusted state, and the initial fan duty cycle corresponding to each fan is updated with the output fan duty cycle corresponding to the fan, and the operation of, based on the target sequence of the plurality of fans, sequentially traversing out each fan as a candidate fan is repeated, namely, the step 102 is repeated.

In an example, the detected state data corresponding to the network device may include but not limited to: sensor data corresponding to each board in the network device, system data corresponding to the network device, and the target fan duty cycle corresponding to each fan. The sensor data corresponding to each board may include at least one of: junction temperature data corresponding to chips in the board, a maximum temperature corresponding to each temperature measuring point in the board, and a power corresponding to the board; and the system data may include at least one of: an ambient temperature, a power of an electrical source, and a power corresponding to each fan.

In an example, before the detected state data is input to the target action model, the target action model may be trained, and a training process of the target action model may include: in response to that the network device is in a stable state, obtaining sample state data corresponding to the network device; inputting the sample state data to an initial action model to obtain a sample fan duty cycle corresponding to each fan; and, inputting the sample state data and the sample duty cycle corresponding to each fan to an initial evaluation model to obtain an state action value corresponding to the sample state data; based on the sample state data, determining a reward parameter value corresponding to the state action value; based on the reward parameter value and the state action value, training the initial action model and the initial evaluation model to obtain a trained target action model and target evaluation model.

In an example, obtaining the trained target action model and target evaluation model by training the initial action model and the initial evaluation model based on the reward parameter value and the state action value may include but not limited to: based on the state action value, determining a first error value corresponding to the initial action model, and based on the first error value, adjusting network parameters of the initial action model to obtain an adjusted action model; based on the reward parameter value and the state action value, determining a second error value corresponding to the initial evaluation model, and based on the second error value, adjusting network parameters of the initial evaluation model to obtain an adjusted evaluation model; if the adjusted action model and the adjusted evaluation model have converged, determining the adjusted action model as the target action model and the adjusted evaluation model as the target evaluation model; if the adjusted action model and/or the adjusted evaluation model have not converged, determining the adjusted action model as the initial action model and the adjusted evaluation model as the initial evaluation model and repeating the operation of inputting the sample state data to the initial action model.

In an example, determining the first error value corresponding to the initial action model based on the state action value may include but not limited to: determining the first error value based on the following formula: $L(\Theta_v) = -critic(s, a)$. Based on the reward parameter value and the state action value, determining the second error value corresponding to the initial evaluation model may include but not limited to: determining the second error value based on the following formula: $L(\Theta_u) = 1/(r' - critic(s, a))^2$. In the above formulas, $L(\Theta_v)$ represents the first error value and $L(\Theta_u)$ represents the second error value, s represents the sample state data, *a* represents the sample fan duty cycle, *critic(s, a)* represents the state action value, and *r'* represents the reward parameter value.

It can be seen from the above technical solutions that in the embodiments of the present disclosure, multiple adjustments are performed on the initial fan duty cycle of each fan to obtain multiple different candidate fan duty cycles; an optimal reward parameter value is selected from the reward parameter values corresponding to the multiple candidate fan duty cycles, and a candidate fan duty cycle corresponding to the optimal reward parameter value is determined as a target fan duty cycle corresponding to the fan so as to obtain the target fan duty cycle corresponding to each fan. Based on the target fan duty cycle corresponding to each fan, a rotation speed of the fan is determined. In this way, the rotation speed of each fan can be effectively controlled to reduce the power consumption and the noise of the fan. Thus, it can be guaranteed that the fans produce smaller noise, and consume less power while avoiding excessively-high temperature of the network device, thereby achieving the purpose of energy saving and noise reduction. Hence, the requirements of the network device for energy saving and noise reduction can be satisfied, and both noise pollution and inhaling of harmful substances such as dusts in the air can be diminished, helping reduce corrosion to the network device.

The technical solutions will be further described in details in combination with specific application scenarios.

A network device (e.g. a router and a switch etc. where the switch may be a chassis switch) may include a plurality of boards (e.g. master control board, interface board, service board and the like) and a plurality of fans. During operation process of these boards, the network device may have an increase in temperature. For this, the fans are used to cool down the network device to avoid excessively high temperature of the network device, thereby avoiding failure of the network device. Obviously, if the fans rotate at a higher speed, the network device can be cooled down more effectively; if the fans rotate at a lower speed, the network device can be cooled down less effectively. When the fans rotate at a higher speed, the fans may produce larger noise and consume more power, leading to energy wastes. When the fans rotate at a lower speed, the fans may produce smaller noise and consume less power, reducing energy wastes.

To sum up, it can be seen that, when the fans rotate at a higher speed, the network device can be cooled down more effectively, but the fans may produce larger noise and consume more power. In contrast, when the fans rotate at a lower speed, the network device will be cooled down less effectively, but the fans may produce smaller noise and consume less power. Therefore, it is necessary to control a rotation speed of the fans to ensure the fans produce smaller noise, and consume less power while avoiding excessively-high temperature of the network device, thereby achieving the purpose of energy saving and noise reduction.

However, in the prior arts, there is still no effective implementation for controlling a rotation speed of the fans to ensure the fans produce smaller noise and consume less power while avoiding excessively-high temperature of the network device.

For example, the rotation speed of the fans may be reduced as much as possible so as to reduce the noise and the power consumption of the fans. But, excessively low rotation speed of the fans may result in increase of the temperature of the network device. For high-power chips inside the network device, along with the increase of the temperature of the network device, the power of the high-power chips may be increased, that is, the entire power consumption of the network device will be increased. Thus, the reduced rotation speed of the fans leads to larger entire power consumption.

For another example, an empirical temperature may be set. When the temperature of the network device is higher than the empirical temperature, the rotation speed of the fans is increased; when the temperature of the network device is lower than the empirical temperature, the rotation speed of the fans is decreased. But, it is difficult to set the empirical temperature accurately. When the empirical temperature is not appropriate, it is required to perform repetitive adjustments on the rotation speed of the fans, leading to up-and-down fluctuations of the temperature of the network device. For example, when the rotation speed of the fans is increased, the temperature of the network device will be lower than the empirical temperature, and hence the rotation speed of the fans is adjusted to be decreased. But, after the rotation speed of the fans is decreased, the temperature of the network device will be higher than the empirical temperature, and hence the rotation speed of the fans is adjusted to be increased. Thus, fluctuations in the rotation speed may occur when adjusting the rotation speed of the fans.

For the above findings, in order to satisfy the requirements of the network device for energy saving and noise reduction, an embodiment of the present disclosure provides a method for controlling a rotation speed of fans. Control on the rotation speed of the fans can be achieved based on Proportion Integral Differential (PID) algorithm, Greedy algorithm and Deep Deterministic Policy Gradient (DDPG) algorithm, so as to effectively control the rotation speed of each fan and reduce the power consumption and the noise of the fans while avoiding excessively high temperature of the network device.

As shown in FIG. 2, after the network device is powered on for startup, it is determined that the network device is in a powered startup state. When the network device is in a powered startup state, control on the rotation speed of the fans is performed based on PID algorithm, until the absolute value of the difference between the temperature value of each board and the target temperature value is less than the temperature threshold. At this time, it is determined that the network device is in a to-be-adjusted state. When the network device is in a to-be-adjusted state, control on the rotation speed of the fans is performed based on Greedy algorithm until a local optimal solution of each fan is found (i.e., the local optimal fan duty cycle denoted as the target fan duty cycle of the fan). Based on the target fan duty cycle of each fan, control on the rotation speed of the fan is performed and it is determined that the network device is in a stable state, namely, the network device reaches a locally-optimal stable state.

The data collected during the process of Greedy algorithm may be used to train a DDPG model. When the network device is in a stable state, the DDPG model may be used to determine whether to restart the Greedy algorithm. For example, if it is determined based on the DDPG model that change occurs to the environment and the power under the stable state, the Greedy algorithm is triggered to re-seek a next local optimal solution. That is, it can be re-determined that the network device is in a to-be-adjusted state. Then, based on the Greedy algorithm, control on the rotation speed of the fans is performed until the target fan duty cycle of each fan is found. Based on the target fan duty cycle of each fan, control on the rotation speed of the fans is performed and the network device is determined to be in a stable state.

Based on the above technical idea, the technical solutions of the embodiments of the present disclosure may involve the following process.

Firstly, after the network device is powered on for startup, based on the temperature value of each board of the network device, a to-be-adjusted fan duty cycle corresponding to each fan is determined; based on the rotation speed corresponding to the to-be-adjusted fan duty cycle corresponding to each fan, the fan is controlled (for example, based on the rotation speed corresponding to the to-be-adjusted fan duty cycle corresponding to the fan 1, the fan 1 is controlled, and based on the rotation speed corresponding to the to-be-adjusted fan duty cycle corresponding to the fan 2, the fan 2 is controlled and so on.). When each fan is controlled based on the rotation speed corresponding to the to-be-adjusted fan duty cycle corresponding to the fan, it is enabled that the absolute value of the difference between the temperature value of each board and the target temperature value is less than the temperature threshold (configured based on experiences) by continuously adjusting the to-be-adjusted fan duty cycle corresponding to each fan. That is, when the absolute value of the difference is greater than the temperature threshold, the to-be-adjusted fan duty cycle corresponding to the fan may be increased to decrease the temperature value of the board; when the absolute value of the difference is less than the temperature threshold, the to-be-adjusted fan duty cycle corresponding to the fan may be decreased to increase the temperature value of the board. By repeatedly adjusting the to-be-adjusted fan duty cycle corresponding to each fan, the absolute value of the difference between the temperature value of each board and the target temperature value is less than the temperature threshold.

In a possible implementation, based on the temperature value of each board of the network device, the to-be-adjusted fan duty cycle corresponding to each fan is determined based on the PID algorithm. By continuously adjusting the to-be-adjusted fan duty cycle corresponding to each fan based on the PID algorithm, the absolute value of the difference between the temperature value of each board and the target temperature value is less than the temperature threshold. The process of determining the to-be-adjusted fan duty cycle based on the PID algorithm is not limited to the embodiments.

In conclusion, in the embodiments, after the network device is powered on for startup, the temperature, power consumption and so on may change quickly. In order to guarantee the security of the network device, the to-be-adjusted fan duty cycle corresponding to each fan may be adjusted continuously based on the PID algorithm, such that the temperature value of each board reaches a stable value. Herein, the fact that the temperature value of the board reaches the stable value means that the absolute value of the difference between the temperature value of the board and the target temperature value is less than the temperature threshold, that is, the temperature value of the board is around the target temperature value and slightly fluctuates around the target temperature value.

In an example, after the absolute value of the difference between the temperature value of each board and the target temperature value is less than the temperature threshold, that is, when the temperature value of each board reaches a stable value, it is determined that the network device is in a to-be-adjusted state. When the network device is in a to-be-adjusted state, control on the rotation speed of the fans may be performed based on the Greedy algorithm rather than on PID algorithm. The control process can be referred to the subsequent embodiments.

When the network device is in a to-be-adjusted state, the initial fan duty cycle corresponding to each fan is updated with the to-be-adjusted fan duty cycle corresponding to the fan, and based on the rotation speed corresponding to the initial fan duty cycle corresponding to each fan, the fan is controlled. For example, based on the rotation speed corresponding to the initial fan duty cycle corresponding to the fan 1, the fan 1 is controlled; based on the rotation speed corresponding to the initial fan duty cycle corresponding to the fan 2, the fan 2 is controlled, and so on.

In a possible implementation, after the network device is started up, if an artificial intelligence fan speed adjustment algorithm is not enabled for the network device, control on the rotation speed of the fans may not be performed based on the algorithm of the present embodiment. After the artificial intelligence fan speed adjustment algorithm is enabled for the network device, control on the rotation speed of the fans is performed based on the PID algorithm.

Secondly, when the network device is in a to-be-adjusted state, control on the rotation speed of the fans is performed based on the Greedy algorithm until the target fan duty cycle of each fan is found. Based on the target fan duty cycle of each fan, control on the rotation speed of the fans is performed. For example, the target fan duty cycle of each fan may be obtained in the following steps.

At step S11, an initial fan duty cycle currently used by each fan is determined.

At step S12, based on a target sequence of the plurality of fans, each fan is sequentially traversed out as a candidate fan.

For example, a plurality of fans may be ranked randomly and the random sequence is taken as the target sequence of the plurality of fans. If the target sequence is fan 1, fan 2, and fan 3, the fan 1 is firstly traversed out as a candidate fan, and then the fan 2 is traversed out as a candidate fan, and finally the fan 3 is traversed out as a candidate fan.

At step S13, for each candidate fan, multiple adjustments are performed on the initial fan duty cycle corresponding to the candidate fan to obtain multiple different candidate fan duty cycles. For each candidate fan duty cycle, reward data of the network device under the candidate fan duty cycle is obtained, and based on the reward data, a reward parameter value corresponding to the candidate fan duty cycle is determined. An optimal reward parameter value is selected from the reward parameter values corresponding to the multiple candidate fan duty cycles, and the candidate fan duty cycle corresponding to the optimal reward parameter value is determined as a target fan duty cycle corresponding to the candidate fan.

For example, it is assumed that the fan 1 corresponds to the initial fan duty cycle 1, the fan 2 corresponds to the initial fan duty cycle 2, and the fan 3 corresponds to the initial fan duty cycle 3. When the fan 1 is traversed out as a candidate fan, multiple adjustments are performed on the initial fan duty cycle 1 corresponding to the fan 1 to obtain a candidate fan duty cycle 1-1, and a candidate fan duty cycle 1-2 and the like. Based on the candidate fan duty cycle 1-1, the initial fan duty cycle 2 and the initial fan duty cycle 3, the reward data is obtained, and based on the reward data, a reward parameter value corresponding to the candidate fan duty cycle 1-1 is determined. Based on the candidate fan duty cycle 1-2, the initial fan duty cycle 2 and the initial fan duty cycle 3, the reward data is obtained, and based on the reward data, a reward parameter value corresponding to the candidate fan duty cycle 1-2 is determined, and so on. If the reward parameter value corresponding to the candidate fan duty cycle 1-2 is the optimal reward parameter value, the candidate fan duty cycle 1-2 is taken as the target fan duty cycle corresponding to the fan 1, where the target fan duty cycle is denoted as target fan duty cycle 1-2.

When the fan 2 is traversed out as a candidate fan, multiple adjustments are performed on the initial fan duty cycle 2 corresponding to the fan 2 to obtain a candidate fan duty cycle 2-1 and a candidate fan duty cycle 2-2 and the like. Based on the candidate fan duty cycle 1-2 (the initial fan duty cycle 1 of the fan 1 has already been adjusted to the target fan duty cycle 1-2), the candidate fan duty cycle 2-1 and the initial fan duty cycle 3, the reward data is obtained, and based on the reward data, a reward parameter value corresponding to the candidate fan duty cycle 2-1 is determined and so on. Thus, the reward parameter value corresponding to each candidate fan duty cycle can be obtained. If the reward parameter value corresponding to the candidate fan duty cycle 2-1 is the optimal reward parameter value, the candidate fan duty cycle 2-1 is taken as the target fan duty cycle corresponding to the fan 2. In this way, the target fan duty cycle corresponding to each fan can be obtained.

In an example, obtaining the reward data based on the candidate fan duty cycle 1-1, the initial fan duty cycle 2 and the initial fan duty cycle 3 refers to, on the basis of controlling the rotation speed of the fan 1 based on the candidate fan duty cycle 1-1 (as the initial fan duty cycle), controlling the rotation speed of the fan 2 based on the initial fan duty cycle 2, and controlling the rotation speed of the fan 3 based on the initial fan duty cycle 3, obtaining the reward data corresponding to the network device.

In an example, performing multiple adjustments on the initial fan duty cycle 1 to obtain a plurality of candidate fan duty cycles refers to that: in a first adjustment, the initial fan duty cycle 1 is adjusted up (or down) to obtain the candidate fan duty cycle 1-1; in a second adjustment, if the reward parameter value corresponding to the initial fan duty cycle 1 is superior to the reward parameter value corresponding to the candidate fan duty cycle 1-1, it means adjusting up results in a worse reward parameter value, and thus it is required to adjust down the initial fan duty cycle 1 to obtain the candidate fan duty cycle 1-2; if the reward parameter value corresponding to the candidate fan duty cycle 1-1 is superior to the reward parameter value corresponding to the initial fan duty cycle 1, it means that adjusting up results in a better reward parameter value, and thus it is required to continue adjusting up the initial fan duty cycle 1 to obtain the candidate fan duty cycle 1-2. In this way, during each adjustment, the fan duty cycle is always adjusted toward better reward parameter value so as to finally obtain a local optimal solution, i.e., the target fan duty cycle.

In an example, the reward data corresponding to the network device may include but not limited to: the fan duty cycle corresponding to each fan (i.e., the fan duty cycle currently used; if the initial fan duty cycle corresponding to the fan is adjusted to the candidate fan duty cycle, the candidate fan duty cycle is taken as the reward data; if the initial fan duty cycle corresponding to the fan is adjusted to the target fan duty cycle, the target fan duty cycle is taken as the reward data; if the initial fan duty cycle corresponding to the fan is not adjusted, the initial fan duty cycle is taken as the reward data); a power of an electrical source; and powers corresponding to all boards and powers corresponding to all fans.

In an example, based on the reward data, a total system power and a fan duty cycle maximum value may be determined; where the reward data includes the fan duty cycle corresponding to each fan, and the fan duty cycle maximum value is a maximum value of all the fan duty cycles; if the reward data includes a power of an electrical source, the total system power is determined based on the power of the electrical source; and if the reward data includes a power corresponding to each board and a power corresponding to each fan, the total system power is determined based on the powers corresponding to all boards and the powers corresponding to all fans. Then, based on the fan duty cycle maximum value, a target noise value is determined, and based on the total system power and a first weight coefficient corresponding to the total system power, the target noise value and a second weight coefficient corresponding to the target noise value, the reward parameter value is determined.

For example, the reward parameter value may be determined based on the following formula, which is not limited herein.

$$r = \omega_1 \times E + \omega_2 \times N(S)$$

In the above formula, $r$ represents a reward parameter value, $\omega_1$ represents the first weight coefficient corresponding to the total system power $E$, and $E$ represents the total system power, where the total system power $E$ may be determined based on the power of the electrical source, that is, the total system power $E$ is the power of the electrical source; or, the total system power $E$ may be determined based on the powers corresponding to all boards and the powers corresponding to all fans, that is, the total system power $E$ is a sum of the powers corresponding to all boards and the powers corresponding to all fans.

In the above formula, $\omega_2$ represents the second weight coefficient corresponding to the target noise value $N(S)$, $S$ represents the fan duty cycle maximum value, i.e., the maximum value of the fan duty cycles corresponding to all fans, which is also called maximum fan duty cycle. $N(S)$ represents the target noise value, where N represents a configured function which is not limited herein, and can be configured based on experiences. The configured function N represents a function relationship between the fan duty cycle maximum value and the target noise value, that is, the input of the configured

**EP 4 424 998 B1**

function N is the fan duty cycle maximum value, and the output of the configured function N is the target noise value. Hence, the fan duty cycle maximum value can be substituted into the configured function N to obtain the target noise value.

It can be seen from the above formula that, the reward parameter value may be determined based on the total system power, the first weight coefficient corresponding to the total system power, the target noise value and the second weight coefficient corresponding to the target noise value.

In a possible implementation, based on the requirements of a user for energy saving and noise reduction, the first weight coefficient $\omega_1$ corresponding to the total system power and the second weight coefficient $\omega_2$ corresponding to the target noise value may be adjusted, where the first weight coefficient $\omega_1$ represents a weight size of energy saving, and the second weight coefficient $\omega_2$ represents a weight size of noise reduction.

In an example, a sum of the first weight coefficient $\omega_1$ and the second weight coefficient $\omega_2$, may be a fixed value (for example, 1), that is, $\omega_1 + \omega_2 = 1$. Based on the requirements of user for energy saving and noise reduction, the first weight coefficient $\omega_1$ and the second weight coefficient $\omega_2$ are adjusted. For example, if the energy saving is more important than the noise reduction, the first weight coefficient $\omega_1$ may be greater than the second weight coefficient $\omega_2$; if the noise reduction is more important than the energy saving, the first weight coefficient $\omega_1$ may be smaller than the second weight coefficient $\omega_2$. The values of the first weight coefficient $\omega_1$ and the second weight coefficient $\omega_2$ are not limited in the present embodiment and can be configured based on experiences.

In conclusion, each time the initial fan duty cycle corresponding to the candidate fan is adjusted to obtain a candidate fan duty cycle, the reward data under the candidate fan duty cycle may be collected, and then, the reward parameter value corresponding to the candidate fan duty cycle is obtained, and thus the multiple reward parameter values corresponding to multiple candidate fan duty cycles may be obtained. An optimal reward parameter value, for example, a minimum reward parameter value, is selected from the multiple reward parameter values corresponding to multiple candidate fan duty cycles, and then a candidate fan duty cycle corresponding to the optimal reward parameter value is taken as the target fan duty cycle. In this way, the target fan duty cycle corresponding to each fan can be obtained.

At step S14, after the target fan duty cycle corresponding to each fan is obtained, a total number of the fans satisfying target conditions in all the fans is calculated, where the fans satisfying the target conditions are fans with unchanged fan duty cycles, that is, the target fan duty cycles are already locally optimal and it is no longer required to adjust the target fan duty cycles of the fans.

For example, for each fan, if the target fan duty cycle corresponding to the fan is identical to the initial fan duty cycle corresponding to the fan, the fan satisfies the target conditions; if the target fan duty cycle corresponding to the fan is different from the initial fan duty cycle corresponding to the fan, the fan does not satisfy the target conditions. After the above processing is performed on each fan, the total number of the fans satisfying the target conditions in all the fans may be obtained.

At step S15, whether the total number of the fans satisfying the target conditions is not less than a preset threshold (e.g. all fans * a%, where a may be 100, or 90 or the like) is determined. If the total number of the fans satisfying the target conditions is not less than the preset threshold, step S16 is performed, and otherwise, step 17 is performed.

At step S16, it is determined that the network device is in a stable state, that is, the target fan duty cycle corresponding to each fan is obtained, and then based on the rotation speed corresponding to the target fan duty cycle corresponding to each fan, the fan is controlled.

In an example, if the total number of the fans satisfying the target conditions is greater than or equal to the preset threshold, it means that the target fan duty cycles corresponding to all or most of the fans are identical to the initial fan duty cycles, that is, the fan duty cycles are not changed. Thus, the target fan duty cycles of these fans are already local optimal solutions and the optimal reward parameter values are already found and therefore it is not necessary to continue adjusting the fan duty cycles. At this point, the network device reaches a stable state and the fan duty cycles are no longer adjusted.

In conclusion, the target fan duty cycle corresponding to each fan is obtained. Thus, based on the rotation speed corresponding to the target fan duty cycle corresponding to each fan, the fan is controlled. The process for controlling the fan based on the target fan duty cycle will not be repeated herein.

At S17, it is determined that the network device is in a to-be-adjusted state (i.e., the state has not changed), and the initial fan duty cycle corresponding to each fan is updated with the target fan duty cycle corresponding to the fan, and the step S12 is repeated.

In an example, if the total number of the fans satisfying the target conditions is less than the preset threshold, it means that the target fan duty cycles corresponding to most of the fans are different from the initial fan duty cycles, that is, the fan duty cycles are changed. Thus, the target fan duty cycles of these fans are not local optimal solutions, and the optimal reward parameter values have not been found, and thus, it is required to continue adjusting the fan duty cycles.

When continuing adjusting the fan duty cycles, the initial fan duty cycle corresponding to each fan may be updated with the target fan duty cycle corresponding to the fan. Based on these initial fan duty cycles, the step S12 is repeated. When the step S12 is repeated, the target sequence (i.e., random sequence) of the plurality of fans may be re-determined. The target sequence of the plurality of fans may be changed or may not be changed.

In conclusion, by repeating the steps S12 to S17, multiple iterations can be performed on the initial fan duty cycle corresponding to each fan, until the total number of the fans satisfying the target conditions is greater than or equal to the preset threshold. Once the network device reaches a stable state, the target fan duty cycle corresponding to each fan can be output.

Thirdly, during operation of the network device, in order to guarantee the security of the network device, temperature detection may be performed on each temperature control point of the network device. If a temperature value of a temperature control point is greater than a preset temperature threshold, it means that the network device is in a danger of high temperature, and the network device gives out a temperature alarm. When the network device gives out a temperature alarm, the to-be-adjusted fan duty cycle corresponding to each fan may be determined by using the PID algorithm based on the temperature value of each board of the network device, and based on the rotation speed corresponding to the to-be-adjusted fan duty cycle corresponding to each fan, the fan is controlled. In this way, the absolute value of the difference between the temperature value of each board and the target temperature value is less than the temperature threshold, so as to ensure the security of the network device. The specific process may be referred to the above described content and will not be repeated herein.

Fourthly, after the network device is in a stable state, a running environment of the network device may also be detected periodically. If the running environment of the network device is changed, the network device may be adjusted from the stable state to a to-be-adjusted state. When the network device is in a to-be-adjusted state, control on the rotation speed of the fans is performed by reusing the Greedy algorithm until the target fan duty cycle of each fan is found. Once the target fan duty cycle of each fan is found, control on the rotation speed of the fans is performed based on the target fan duty cycle of each fan. The specific process of the Greedy algorithm may be referred to the above described content and will not be repeated herein.

If there is a plug operation for a board in the network device, it is determined that the running environment of the network device is changed. In an example, if the ambient temperature of the network device is changed greatly, it is determined that the running environment of the network device is changed. In an example, if a forwarding flow of the network device is increased much, it is determined that the running environment of the network device is changed. In an example, if a forwarding flow of the network device is decreased much, it is determined that the running environment of the network device is changed. Of course, the above descriptions are made only to several examples and not limited thereto.

Since the running environment of the network device has strong stability and changes little, the network device can remain in a stable state for a very long time, and the target fan duty cycle of each fan will not be repeatedly adjusted.

In an example, by referring to the step S16, in response to that the network device is in a stable state, the reward data (i.e., the reward data includes the target fan duty cycle of each fan) of the network device under the target fan duty cycle may be obtained, and based on the reward data, the reward parameter value corresponding to the target fan duty cycle is determined, where the reward parameter value is denoted as a reward parameter value X1.

In response to that the network device is in a stable state, the reward data (although the fan duty cycle in the reward data does not change, the power of the electrical source, the powers corresponding to the boards and the powers corresponding to the fans may change) corresponding to the network device may also be obtained periodically and based on the reward data, a reward parameter value X2 is determined.

If the reward parameter value X2 is superior to the reward parameter value X1 and a difference between the reward parameter value X1 and the reward parameter value X2 is large (for example, greater than a threshold), that is, the reward parameter value changes much, the network device may be adjusted from the stable state to a to-be-adjusted state. When the network device is in a to-be-adjusted state, control on the rotation speed of the fans is performed by reusing the Greedy algorithm until the target fan duty cycle of each fan is found.

If the reward parameter value X1 is superior to the reward parameter value X2, or although the reward parameter value X2 is superior to the reward parameter value X1, if the difference between the reward parameter value X1 and the reward parameter value X2 is small, the network device can be maintained in a stable state without adjusting the target fan duty cycle of each fan.

Fifthly, sample state data corresponding to the network device is obtained, and based on the sample state data, a target action model and a target evaluation model are obtained by training. The sample state data includes the sample state data of the network device in a to-be-adjusted state, and/or, the sample state data of the network device in a stable state.

For example, the target action model and the target evaluation model may be obtained by training based on the following steps.

At step S21, the sample state data corresponding to the network device is obtained.

In an example, the sample state data corresponding to the network device may include but not limited to at least one of: sensor data corresponding to each board in the network device, system data corresponding to the network device, and the fan duty cycle corresponding to each fan (i.e., the fan duty cycle of the fan in a current running process). The sensor data corresponding to each board may include but not limited to at least one of: junction temperature data corresponding to chips in the board, a maximum temperature corresponding to each temperature measuring point in the board, and a power corresponding to the board; and the system data may include but not limited to at least one of: an ambient temperature, a power of an electrical source, and a power corresponding to each fan.

For example, when the network device is in a to-be-adjusted state or a stable state, the sample state data of the network device may be obtained in each collection period. An interval between two adjacent collection periods may be arbitrarily configured, for example, as 3 seconds, 5 seconds, or 8 seconds or the like, which is not limited herein.

For each board, if the board includes at least one of the following chips: an MAC chip, a Central Processing Unit (CPU) chip, a Field Programmable Gate Array (FPGA) chip, an Artificial Intelligence (AI) chip, and an optical module chip, the junction temperatures (actual working temperatures) of these chips may be collected and then taken as the sample state data corresponding to the network device.

For each board, if the board includes at least one temperature measuring point, a temperature value corresponding to each temperature measuring point in the board may be collected, and a maximum value of these temperature values is selected as a maximum temperature value corresponding to each temperature measuring point in the board and the maximum temperature value is taken as the sample state data corresponding to the network device.

For each board, a power corresponding to the board, i.e., a power currently used by the board, may be collected and taken as the sample state data corresponding to the network device.

For the network device, an ambient temperature and a power of the electrical source of the network device may be collected, and the ambient temperature and the power of the electrical source of the network device are taken as the sample state data corresponding to the network device.

For each fan, a power corresponding to the fan, i.e., a power currently used by the fan, may be collected and the power corresponding to the fan is taken as the sample state data corresponding to the network device.

For each fan, the fan duty cycle corresponding to the fan, i.e., a fan duty cycle in a current running process, may be collected, which indicates the fan is rotating at the rotation speed corresponding to the fan duty cycle. In an example, the fan duty cycle represents a rotation speed of a fan and may be an integer between a minimum fan duty cycle and a maximum fan duty cycle. For example, the minimum fan duty cycle is 20 and the maximum fan duty cycle is 100. In this case, the fan duty cycle may be an integer between 20 and 100, for example, 20, 25, 50, or 100 or the like. If the maximum rotation speed of the fan is k (a maximum rotational capability supported by the fan) and the fan duty cycle is m, the rotation speed of the fan may be m% * k, that is, the rotation speed of the fan is m% of the maximum rotation speed k. For example, when the fan duty cycle is 20, it indicates that the rotation speed of the fan is 20% of the maximum rotation speed k.

At step S22, a configured initial action model and a configured initial evaluation model are obtained.

In this embodiment, an initial action model may be pre-configured. The input data of the initial action model is the sample state data corresponding to the network device, and the output data of the initial action model is the fan duty cycles corresponding to all fans (for ease of distinguishing, the fan duty cycles are referred to as sample fan duty cycles). That is, the sample fan duty cycles corresponding to all fans of the network device are taken as a whole and used as the output data of the initial action model.

For example, the initial action model may be a deep learning model or a neural network model, which is not structurally limited herein. The initial action model may be arbitrarily configured as long as it can convert the sample state data corresponding to the network device into the sample fan duty cycles corresponding to all fans.

In the present embodiment, the initial evaluation model may be pre-configured. The input data of the initial evaluation model is the sample state data corresponding to the network device and the sample fan duty cycles corresponding to all fans (i.e., the output data of the initial action model), and the output data of the initial evaluation model is a state action value for reflecting the value of a state and an action. The state herein may be the sample state data, and the action herein may be the sample fan duty cycles corresponding to all fans. That is, the state action value is used to reflect the value of the sample state data and the sample fan duty cycles corresponding to all fans.

For example, the initial evaluation model may be a deep learning model or a neural network model, which is not structurally limited herein. The initial evaluation model may be arbitrarily configured as long as it can convert the sample state data and the sample fan duty cycles corresponding to all fans into the state action value.

In a possible implementation, the initial action model and the initial evaluation model may be network models based on DDPG algorithm, or network models based on another algorithm, which is not limited herein. For ease of descriptions, in this embodiment, the initial action model and the initial evaluation model both based on the DDPG algorithm are taken as an example.

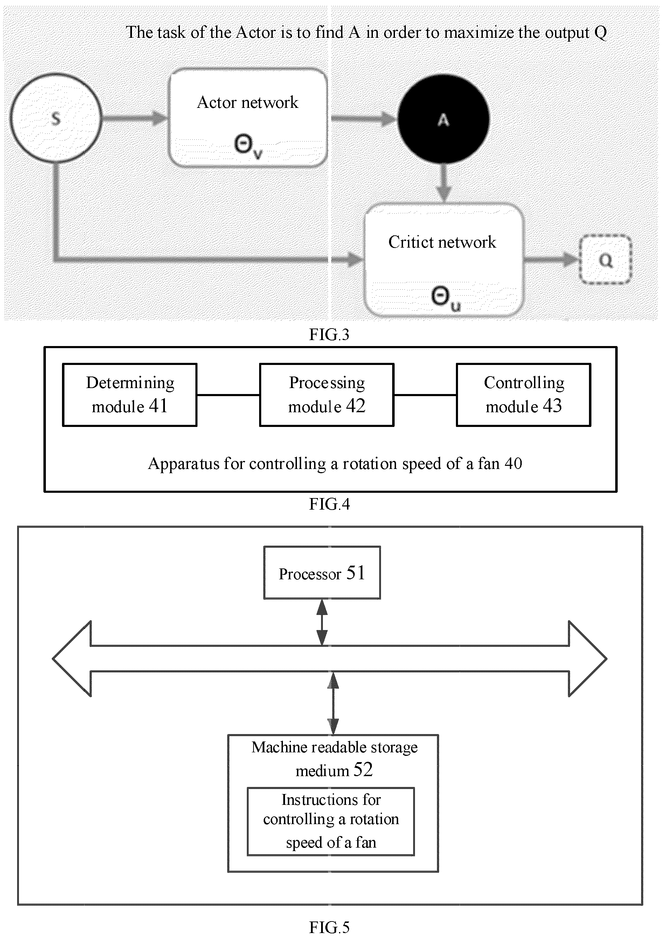

For example, FIG. 3 shows an example of the initial action model and the initial evaluation model both based on the DDPG algorithm, where the Actor network is the initial action model and the Critic network is the initial evaluation model. S is the input data of the initial action model as well as the input data of the initial evaluation model. In this embodiment, S represents the sample state data corresponding to the network device. A is the output data of the initial action model as well as the input data of the initial evaluation model. In this embodiment, A represents the sample fan duty cycles corresponding to all fans (i.e., the Action of the Actor network). Q is the output data of the initial evaluation model, and in this embodiment, Q represents the state action value.

The DDPG algorithm is a deep deterministic policy gradient algorithm which is proposed for controlling continuous actions. The deterministic policy of the DDPG algorithm is relative to a stochastic policy. Some action sets may include continuous values or high-dimensional discrete values, such that the action space has large dimension. The DDPG algorithm uses the deterministic policy to simplify the problem. The deterministic in the DDPG algorithm means the continuous actions output a specific value. When the actions are discrete, a probability of occurrence of each action is output based on the target of maximizing long-term benefits; when the actions are continuous, only a specific value can be output based on the target of maximizing long-term benefits, the specific value representing a specific action. Thus, a deterministic policy can be obtained.

Based on the above principles of the DDPG algorithm, in this embodiment, the initial action model and the initial evaluation model can be implemented based on the DDPG algorithm. The DDPG algorithm is based on Actor-Critict architecture to process the continuous action space. Therefore, the Actor network may be taken as the initial action model and the Critict network may be taken as the initial evaluation model. In this embodiment, the continuous action space refers to the sample fan duty cycles corresponding to all fans. For the sample fan duty cycle corresponding to each fan, the sample fan duty cycle may be one of continuous integers between the minimum fan duty cycle and the maximum fan duty cycle, rather than one of discrete integers between the minimum fan duty cycle and the maximum fan duty cycle. For example, the sample fan duty cycle may be the continuous integer such as 20, 21, 22, ... and 100 rather than the discrete integer such as 20, 25, 30, 35, ... and 100.

At step S23, the sample state data is input to the initial action model to obtain the sample fan duty cycle (i.e., Action of the initial action model) corresponding to each fan. The sample state data and the sample fan duty cycle corresponding to each fan are input to the initial evaluation model to obtain the state action value corresponding to the sample state data.

For example, the sample state data S corresponding to the network device may be input to the initial action model as the input data such that the initial action model may process the sample state data S to obtain the sample fan duty cycle A corresponding to each fan. The sample fan duty cycles A corresponding to all fans are taken as the Action of the initial action model.

The sample state data S corresponding to the network device and the sample fan duty cycle A corresponding to each fan may be taken as the input data of the initial evaluation model, and the initial evaluation model may perform a corresponding processing based on the sample state data S and the sample fan duty cycle A corresponding to each fan. After the processing, a state action value Q corresponding to the sample state data S is obtained, where the state action value Q may also be referred to as a function value Q which is the output data of the initial evaluation model.

At step S24, based on the sample state data, a reward parameter value corresponding to the state action value is determined.

In an example, a total system power and a fan duty cycle maximum value may be determined based on the sample state data. The sample state data may include the fan duty cycle corresponding to each fan, and the fan duty cycle maximum value may be a maximum value of all the fan duty cycles. If the sample state data includes the power of the electrical source, the total system power may be determined based on the power of the electrical source; if the sample state data includes the power corresponding to each board and the power corresponding to each fan, the total system power may be determined based on the powers corresponding to all boards and the powers corresponding to all fans. Next, a target noise value may be determined based on the fan duty cycle maximum value. Then, based on the total system power, a first weight coefficient corresponding to the total system power, the target noise value and a second weight coefficient corresponding to the target noise value, the reward parameter value corresponding to the state action value is determined. The process of determining the reward parameter value based on the total system power and the fan duty cycle maximum value can be referred to the step S13 and will not be repeated herein.

At step S25, based on the state action value, a first error value corresponding to the initial action model is determined, and based on the first error value, network parameters of the initial action model are adjusted to obtain an adjusted action model; based on the reward parameter value and the state action value, a second error value corresponding to the initial evaluation model is determined, and based on the second error value, network parameters of the initial evaluation model are adjusted to obtain an adjusted evaluation model.

In an example, an error function (i.e., a loss function) corresponding to the initial action model may be configured, where the error function may be configured based on experiences and will not be limited herein. For example, an example of the error function may be $L(\Theta_v) = -critic(s, a)$. Of course, the above formula is only one example of the error function. No limitation is made to the error function as long as the error function is related to the state action value.

On this basis, the first error value may be determined based on the following formula: $L(\Theta_v) = -critic(s,$

*a*). In the above formula, $L(\Theta_v)$ represents the first error value, s represents the sample state data, *a* represents the sample fan duty cycle, and *critic(s, a)* represents the state action value. To sum up, the sample state data s may be input to the initial action model to obtain the sample fan duty cycle *a* corresponding to each fan. Next, the sample state data s and the sample fan duty cycle *a* corresponding to each fan are input to the initial evaluation model to obtain a state action value *critic(s, a)*. After the state action value *critic(s, a)* is obtained, the state action value *critic(s, a)* may be substituted into the above formula to obtain the first error value $L(\Theta_v)$. Obviously, the larger the state action value *critic(s, a)* is, the smaller the first error value $L(\Theta_v)$ is; the smaller the state action value *critic(s, a)* is, the larger the first error value $L(\Theta_v)$ is.

After the first error value $L(\Theta_v)$ is obtained, the network parameters of the initial action model may be adjusted based on the first error value $L(\Theta_v)$. The goal for this adjustment is to make the first error value $L(\Theta_v)$ smaller and smaller, that is, to find a minimum value of the first error value $L(\Theta_v)$ and thus to find an adjusted action model. No limitation is made to the adjustment process herein.

In an example, an error function (i.e., a loss function) corresponding to the initial evaluation model may be configured, where the error function may be configured based on experiences and will not be limited herein. For example, an example of the error function may be $L(\Theta_u) = 1/2(r' - critic(s, a))^2$. Of course, the above formula is only one example of the error function. No limitation is made to the error function as long as the error function is related to the reward parameter value and the state action value.

On this basis, the second error value may be determined based on the following formula: $L(\Theta_u) = 1/2(r' - critic(s, a))^2$. In the above formula, $L(\Theta_u)$ represents the second error value, s represents the sample state data, *a* represents the sample fan duty cycle, *critic(s, a)* represents the state action value, and *r'* represents the reward parameter value. To sum up, the sample state data *s* may be input to the initial action model to obtain the sample fan duty cycle *a* corresponding to each fan. Next, the sample state data *s* and the sample fan duty cycle *a* corresponding to each fan are input to the initial evaluation model to obtain a state action value *critic(s, a)*. After the state action value *critic(s, a)* is obtained, the state action value *critic(s, a)* and the reward parameter value *r'* may be substituted into the above formula to obtain the second error value $L(\Theta_u)$.

Obviously, the larger the state action value *critic(s, a)* is, the smaller the second error value $L(\Theta_u)$; the smaller the state action value *critic(s, a)* is, the larger the second error value $L(\Theta_u)$. The larger the reward parameter value *r'* is, the larger the second error value $L(\Theta_u)$ is; the smaller the reward parameter value *r'* is, the smaller the second error value $L(\Theta_u)$ is.

After the second error value $L(\Theta_u)$ is obtained, the network parameters of the initial evaluation model may be adjusted based on the second error value $L(\Theta_u)$. The goal for this adjustment is to make the second error value $L(\Theta_u)$ smaller and smaller, that is, to find a minimum value of the second error value $L(\Theta_u)$ and thus to find an adjusted evaluation model. No limitation is made to the adjustment process herein.

In an example, it is assumed that the sample state data obtained in a first collection period is a1, the sample state data obtained in a second collection period is a2, and the sample state data obtained in a third collection period is a3. In this case, when the sample state data a1 (i.e. current collection period) is taken as the sample state data s, the sample state data a2 (i.e., next collection period) is taken as the sample state data s'. That is, when the sample state data a2 is taken as the sample state data s, the sample state data a3 is taken as the sample state data s'. Based on the formula $r = \omega_1 \times E + \omega_2 \times N(S)$, the reward parameter value *r* corresponding to the sample state data *s* is obtained and the reward parameter value *r'* corresponding to the sample state data *s'* is also obtained. In conclusion, when the second error value is determined, the reward parameter value *r'* is a reward parameter value corresponding to the sample state values obtained in the next collection period of the current collection period.

At step S26, it is determined whether the adjusted action model and the adjusted evaluation model have converged.

If the adjusted action model and the adjusted evaluation model have converged, step S27 is performed.

If the adjusted action model and/or the adjusted evaluation model have not converged, step S28 is performed.

For example, if the first error value satisfies a first convergence condition, it is determined that the adjusted action model has converged; if the first error value does not satisfy the first convergence condition, it is determined that the adjusted action model has not converged. The first convergence condition may be configured based on experiences and is not limited herein. For example, when the first error value falls within a preset value interval, the first error value satisfies the first convergence condition and otherwise, the first error value does not satisfy the first convergence condition.

If the second error value satisfies a second convergence condition, it is determined that the adjusted evaluation model has converged; if the second error value does not satisfy the second convergence condition, it is determined that the adjusted evaluation model has not converged. The second convergence condition may be configured based on experiences and is not limited herein. For example, when the second error value falls within a preset value interval, the second error value satisfies the second convergence condition and otherwise, the second error value does not satisfy the second convergence condition.

For another example, if a number of iterations of the initial action model reaches a first number threshold (may be configured based on experiences without any limitations), it is determined that the adjusted action model has converged; if the number of iterations of the initial action model does not reach the first number threshold, it is determined that the adjusted action model has not converged.

If a number of iterations of the initial evaluation model reaches a second number threshold (may be configured based on experiences without any limitations), it is determined that the adjusted evaluation model has converged; if the number of iterations of the initial evaluation model does not reach the second number threshold, it is determined that the adjusted evaluation model has not converged.

For another example, if a time length of iterations of the initial action model reaches a first time length threshold (may be configured based on experiences without any limitations), it is determined that the adjusted action model has converged; if the time length of iterations of the initial action model does not reach the first time length threshold, it is determined that the adjusted action model has not converged.

If a time length of iterations of the initial evaluation model reaches a second time length threshold (may be configured based on experiences without any limitations), it is determined that the adjusted evaluation model has converged; if the time length of iterations of the initial evaluation model does not reach the second time length threshold, it is determined that the adjusted evaluation model has not converged.

Of course, the above descriptions are made only to several examples of determining whether the adjusted action model and the adjusted evaluation model have converged and no limitations are made to the specific determination manner which can be arbitrarily set based on actual requirements.

At step S27, the adjusted action model is determined as the target action model and the adjusted evaluation model is determined as the target evaluation model. Till now, the training process of the initial action model and the initial evaluation model is completed to obtain a trained target action model and a trained target evaluation model.

At step S28, the adjusted action model is determined as the initial action model and the adjusted evaluation model is determined as the initial evaluation model, and the steps S23, S25 and S26 are repeated.

Sixthly, in response to that the network device is in a stable state, the DDPG model (a target action model and a target evaluation model) may be periodically used to determine whether to restart the Greedy algorithm. If it is required to restart the Greedy algorithm, the network device is adjusted from the stable state to a to-be-adjusted state. When the network device is in a to-be-adjusted state, control on the rotation speed of the fans is performed by reusing the Greedy algorithm until the target fan duty cycle of each fan is found. Once the target fan duty cycle of each fan is found, based on the target fan duty cycle of each fan, control on the rotation speed of the fans is achieved. The specific process of the Greedy algorithm may be referred to the above described content and will not be repeated herein. If it is not required to restart the Greedy algorithm, the network device is maintained in a stable state and it is not required to re-determine the target fan duty cycle of each fan, that is, the target fan duty cycle of each fan is maintained unchanged (i.e., maintain the target fan duty cycle determined in the above described content). In a next detection period, the DDPG model is continued to be used to determine whether to restart the Greedy algorithm. For example, whether to adjust the target fan duty cycle may be determined based on the following steps.

At step S31, in response to that the network device is in a stable state, detected state data corresponding to the network device is obtained.

In an example, the detected state data corresponding to the network device may include but not limited to at least one of: sensor data corresponding to each board in the network device, system data corresponding to the network device, and the fan duty cycle corresponding to each fan (i.e., the fan duty cycle of the fan in a current running process, i.e., the target fan duty cycle). The sensor data corresponding to each board includes but not limited to at least one of: junction temperature data corresponding to chips in the board, a maximum temperature corresponding to each temperature measuring point in the board, and a power corresponding to the board; and the system data includes but not limited to at least one of: an ambient temperature, a power of an electrical source, and a power corresponding to each fan.

For each board, if the board includes at least one of the following chips: an MAC chip, a CPU chip, a FPGA chip, an AI chip, and an optical module chip, the junction temperatures (actual working temperatures) of these chips may be collected and then taken as the detected state data corresponding to the network device. If the board includes at least one temperature measuring point, a temperature value corresponding to each temperature measuring point in the board may be collected, and a maximum value of these temperature values is selected as a maximum temperature value corresponding to each temperature measuring point in the board and the maximum temperature value is taken as the detected state data corresponding to the network device. A power corresponding to the board, i.e., a power currently used by the board, may be collected and taken as the detected state data corresponding to the network device.

For the network device, an ambient temperature and a power of an electrical source of the network device may be collected, and the ambient temperature and the power of the electrical source of the network device are taken as the detected state data corresponding to the network device.

For each fan, a power corresponding to the fan, i.e., a power currently used by the fan, may be collected and the power corresponding to the fan is taken as the detected state data corresponding to the network device.

For each fan, the fan duty cycle corresponding to the fan may be collected, which indicates the fan is rotating at the rotation speed corresponding to the fan duty cycle. The fan duty cycle corresponding to the fan may be taken as the detected state data corresponding to the network device. In an example, the fan duty cycle represents a rotation speed of a fan and may be an integer between a minimum fan duty cycle and a maximum fan duty cycle. If the maximum rotation speed of the fan is k and the fan duty cycle is m, the rotation speed of the fan may be m% * k, that is, the rotation speed of the fan is m% of the maximum rotation speed k.

At step S32, the detected state data is input to the trained target action model to obtain the output fan duty cycle corresponding to each fan, where different fans correspond to different output fan duty cycles or a same output fan duty cycle.

In an example, the input data of the initial action model is the sample state data, and the output data of the initial action model is the sample fan duty cycles corresponding to all fans. That is, the sample fan duty cycles corresponding to all fans of the network device are taken as a whole and used as the output data of the initial action model. Based on this, after the target action model is obtained by training, the input data of the target action model is the detected state data, and the output data of the target action model is the output fan duty cycles corresponding to all fans (for ease of distinguishing, the fan duty cycles output by the target action model are referred to as output fan duty cycles), that is, the output fan duty cycles corresponding to all fans of the network device can be taken as a whole and used as the output data of the target action model.

At step S32, the detected state data corresponding to the network device is input to the target action model and is processed by the target action model to obtain the output fan duty cycle corresponding to each fan, where the processing procedure is not limited herein. Different fans correspond to different output fan duty cycles or a same output fan duty cycle.

For example, the detected state data is input to the target action model to obtain the output fan duty cycle corresponding to the fan 1, the output fan duty cycle corresponding to the fan ... and so on.

At step S33, based on the reward data of the network device under the output fan duty cycle corresponding to each fan, a first reward parameter value corresponding to the output fan duty cycles is determined; and based on the reward data of the network device under the target fan duty cycle corresponding to each fan, a second reward parameter value corresponding to the target fan duty cycles is determined.

In an example, the reward data (the reward data includes the output fan duty cycle corresponding to each fan; the power of the electrical source, the power corresponding to each board, the power corresponding to each fan and the like in the reward data correspond to the output fan duty cycles) of the network device under the output fan duty cycle may be obtained. Based on the reward data, the first reward parameter value corresponding to the output fan duty cycles is determined. The reward data (the reward data includes the target fan duty cycle corresponding to each fan; the power of the electrical source, the power corresponding to each board, the power corresponding to each fan and the like in the reward data correspond to the target fan duty cycles) of the network device under the target fan duty cycles may be obtained. Based on the reward data, a second reward parameter value corresponding to the target fan duty cycles is determined. The process of determining the first reward parameter value or the second reward parameter value may be referred to the step S13 and will not be repeated herein.

At step S34, whether the first reward parameter value is superior to the second reward parameter value is determined.

If the first reward parameter value is superior to the second reward parameter value, step S35 is performed.

If the first reward parameter value is not superior to the second reward parameter value, step S36 is performed.

At step S35, it is determined that the network device is in a to-be-adjusted state, and the initial fan duty cycle corresponding to each fan is updated with the output fan duty cycle corresponding to the fan. Control on the rotation speed of the fans is performed by reusing the Greedy algorithm until the target fan duty cycle of each fan is found. Based on the target fan duty cycle of each fan, control on the rotation speed of the fans is performed. The specific process of the Greedy algorithm may be referred to the above described content and will not be repeated herein.

In an example, in response to that the network device is in a stable state, the output fan duty cycle corresponding to each fan may be obtained based on the target action model. If the first reward parameter value corresponding to the output fan duty cycles is superior to the second reward parameter value corresponding to the target fan duty cycles, it is indicated that the target fan duty cycles require to be optimized. The network device may be adjusted from a stable state to a to-be-adjusted state. When the network device is in a to-be-adjusted state, control on the rotation speed of the fans may be performed by reusing the Greedy algorithm until the target fan duty cycle of each fan is found.

At step S36, it is determined that the network device is in a stable state, and the output fan duty cycle corresponding to each fan is restored to the target fan duty cycle corresponding to the fan, and then, control on the rotation speed of the fan is performed based on the target fan duty cycle.

In an example, in response to that the network device is in a stable state, the output fan duty cycle corresponding to each fan may be obtained based on the target action model. If the first reward parameter value corresponding to the output fan duty cycles is not superior to the second reward parameter value corresponding to the target fan duty cycles, it is indicated that the target fan duty cycles do not require to be optimized. The network device is continued to be in stable state, and the output fan duty cycle corresponding to each fan is restored to the target fan duty cycle corresponding to the fan, and the target fan duty cycle corresponding to each fan is continued to be used to achieve control on the rotation speed of the fan.

It can be seen from the above technical solutions that, in the embodiments of the present disclosure, the rotation speed of each fan can be effectively controlled to reduce the power consumption and the noise of the fan. Thus, it can be guaranteed that the fans produce smaller noise, and consume less power while avoiding excessively-high temperature of the network device, thereby achieving the purpose of energy saving and noise reduction. Hence, the requirements of the network device for energy saving and noise reduction can be satisfied, and both noise pollution and inhaling of harmful substances such as dusts in the air can be diminished, helping reduce corrosion to the network device. Based on the requirements of the user for energy saving and noise reduction, a weight coefficient may be adjusted autonomously and a proper reward function is set to obtain a reward parameter value. In order to guarantee the security of the network device, temperature detection may be performed on each temperature control point of the network device. If the network device is in a danger of high temperature, the PID algorithm will be forcibly used to ensure the security of the network device. The Greedy algorithm may be used to seek a locally-optimal stable state, and the DDPG algorithm may be used to introduce a new disturbance value to the network device, helping seek a global optimal solution of the network device.

Based on the same application idea as the above method, an embodiment of the present disclosure provides an apparatus for controlling a rotation speed of a fan 40, which is applied to a network device. The network device includes a plurality of fans. FIG. 4 is a structural schematic diagram of the apparatus. When the network device is in a to-be-adjusted state, the apparatus may include:

a determining module 41, configured to determine an initial fan duty cycle currently used by each fan;

a processing module 42, configured to, based on a target sequence of the plurality of fans, sequentially traverse out each fan as a candidate fan; perform a plurality of adjustments on the initial fan duty cycle corresponding to the candidate fan to obtain a plurality of different candidate fan duty cycles; for each candidate fan duty cycle, obtain reward data of the network device under the candidate fan duty cycle, and based on the reward data, determine a reward parameter value corresponding to the candidate fan duty cycle; select an optimal reward parameter value from the reward parameter values corresponding to the plurality of candidate fan duty cycles, and determine the candidate fan duty cycle corresponding to the optimal reward parameter value as a target fan duty cycle corresponding to the candidate fan; and a controlling module 43, configured to, after the target fan duty cycle corresponding to each fan is obtained, if the network device is in a stable state, based on the rotation speed corresponding to the target fan duty cycle corresponding to each fan, control the fan.

In an example, after obtaining the target fan duty cycle corresponding to each fan, the processing module 42 is further configured to: if the network device is in the to-be-adjusted state, update the initial fan duty cycle corresponding to each fan with the target fan duty cycle corresponding to the fan, and return to perform the operation of, based on the target sequence of the plurality of fans, sequentially traverse out each fan as a candidate fan; where, if a total number of the fans satisfying target conditions is not less than a preset threshold, it is determined that the network device is in the stable state, otherwise, it is determined that the network device is in the to-be-adjusted state; for each fan, if the target fan duty cycle corresponding to the fan is identical to the initial fan duty cycle corresponding to the fan, the fan satisfies the target conditions, otherwise, the fan does not satisfy the target conditions.

In an example, when determining the reward parameter value corresponding to the candidate fan duty cycle based on the reward data, the processing module 42 is specifically configured to: based on the reward data, determine a total system power and a fan duty cycle maximum value; where the reward data includes the fan duty cycle corresponding to each fan, and the fan duty cycle maximum value is a maximum value of all the fan duty cycles; if the reward data includes a power of an electrical source, determine the total system power based on the power of the electrical source; and if the reward data comprises a power corresponding to each board and a power corresponding to each fan, determine the total system power based on the powers corresponding to all the boards and the powers corresponding to all the fans; based on the fan duty cycle maximum value, determine a target noise value; based on the total system power, a first weight coefficient corresponding to the total system power, the target noise value and a second weight coefficient corresponding to the target noise value, determine the reward parameter value.

In an example, a sum of the first weight coefficient and the second weight coefficient is a fixed value; if energy saving is more important than noise reduction, the first weight coefficient is greater than the second weight coefficient; if the noise reduction is more important than the energy saving, the first weight coefficient is less than the second weight coefficient.

In an example, after the network device is powered on for startup or the network device gives out a temperature alarm, the determining module 41 is further configured to: based on a temperature value of each board of the network device, determine a to-be-adjusted fan duty cycle corresponding to each fan; where, when each fan is controlled based on the rotation speed corresponding to the to-be-adjusted fan duty cycle corresponding to the fan, it is enabled that an absolute value of a difference between the temperature value of each board and a target temperature value is less than a temperature threshold; the determining module 41 is further configured to: after the absolute value of the difference between the temperature value of each board and the target temperature value is less than the temperature threshold, determine the network device is in the to-be-adjusted state, and update the initial fan duty cycle corresponding to each fan with the to-be-adjusted fan duty cycle corresponding to the fan; the controlling module 43 is further configured to, based on the rotation speed corresponding to the initial fan duty cycle corresponding to each fan, control the fan.

In an example, in response to that the network device is in the stable state, the processing module 42 is further configured to: obtain detected state data corresponding to the network device; input the detected state data to a trained target action model to obtain an output fan duty cycle corresponding to each fan; where different fans correspond to different output fan duty cycles or a same output fan duty cycle; based on the reward data of the network device under the output fan duty cycle corresponding to each fan, determine a first reward parameter value corresponding to the output fan duty cycles; based on the reward data of the network device under the target fan duty cycle corresponding to each fan, determine a second reward parameter value corresponding to the target fan duty cycles; if the first reward parameter value is superior to the second reward parameter value, determine the network device is in the to-be-adjusted state, update the initial fan duty cycle corresponding to each fan with the output fan duty cycle corresponding to the fan, and return to perform the operation of, based on the target sequence of the plurality of fans, sequentially traversing out each fan as a candidate fan.

In an example, the detected state data corresponding to the network device includes: sensor data corresponding to each board in the network device, system data corresponding to the network device, and the target fan duty cycle corresponding to each fan; where the sensor data corresponding to each board includes at least one of: junction temperature data corresponding to chips in the board, a maximum temperature corresponding to each temperature measuring point in the board, and a power corresponding to the board; and the system data includes at least one of: an ambient temperature, a power of an electrical source, and a power corresponding to each fan.

In an example, the apparatus for controlling a rotation speed of a fan further includes a training module, configured to obtain the target action model by training; when obtaining the target action model by training, the training module is specifically configured to: in response to that the network device is in the stable state, obtain sample state data corresponding to the network device; input the sample state data to an initial action model to obtain a sample fan duty cycle corresponding to each fan; and, input the sample state data and the sample fan duty cycle corresponding to each fan to an initial evaluation model to obtain an state action value corresponding to the sample state data; based on the sample state data, determine a reward parameter value corresponding to the state action value; based on the reward parameter value and the state action value, train the initial action model and the initial evaluation model to obtain a trained target action model and target evaluation model.

In an example, when training the initial action model and the initial evaluation model to obtain a trained target action model and target evaluation model based on the reward parameter value and the state action value, the training module is specifically configured to: based on the state action value, determine a first error value corresponding to the initial action model, and based on the first error value, adjust network parameters of the initial action model to obtain an adjusted action model; based on the reward parameter value and the state action value, determine a second error value corresponding to the initial evaluation model, and based on the second error value, adjust network parameters of the initial evaluation model to obtain an adjusted evaluation model; if the adjusted action model and the adjusted evaluation model have converged, determine the adjusted action model as the target action model and the adjusted evaluation model as the target evaluation model; if the adjusted action model and/or the adjusted evaluation model have not converged, determine the adjusted action model as the initial action model and the adjusted evaluation model as the initial evaluation model and return to perform the operation of inputting the sample state data to the initial action model.

Based on the same application idea as the above method, an embodiment of the present disclosure provides a network device. As shown in FIG. 5, the network device includes a processor 51 and a machine readable storage medium 52 storing machine executable instructions executable by the processor 51; the processor 51 is configured to execute the machine executable instructions to perform the method for controlling a rotation speed of a fan according to the above embodiments of the present disclosure.

Based on the same application idea as the above method, an embodiment of the present disclosure further provides a machine readable storage medium storing several computer instructions, where the computer instructions are executed by a processor to perform the method for controlling a rotation speed of a fan according to the above embodiments of the present disclosure.

The machine readable storage medium mentioned herein may be any of electronic, magnetic, optical or other physical storage devices and may contain or store information such as executable instructions, data and so on. For example, the machine readable storage medium may be a Radom Access Memory (RAM), a volatile or non-volatile memory, a flash memory, a storage drive (e.g. hard disk drive), a solid state harddisk, any type of storage disk (e.g., compact disk, Digital Video Disk (DVD)), or a similar storage medium, or a combination thereof.

The systems, apparatuses, modules or units described in the above embodiments may be specifically implemented by a computer chip or an entity, or may be implemented by a product with a particular function. A typical implementing device may be a computer and the computer may be specifically a personal computer, a laptop computer, a cellular phone, a camera phone, a smart phone, a personal digital assistant, a media player, a navigation device, an email transceiver, a game console, a tablet computer, a wearable device, or a combination of any several devices of the above devices.

For convenience of description, the above apparatus is divided into different units based on functionality for descriptions. Of course, the functions of different units may be implemented in a same or a plurality of hardware and/or software when practicing the present disclosure.

The persons skilled in the art should understand that the embodiments of the present disclosure may be provided as a method, a system, or a computer program product. Thus, entire hardware examples, entire software examples or examples combining software and hardware may be adopted in the present disclosure. Further, the present disclosure may be implemented in the form of a computer program product that is operated on one or more computer available storage media (including but not limited to magnetic disk memory, CD-ROM, and optical memory and so on) including computer available program codes.

The present disclosure is described by referring to flowcharts and/or block diagrams of a method, a device (a system) and a computer program product in an example of the present disclosure. It is understood that each flowchart and/or block in the flowcharts and/or the block diagrams or a combination of a flow chart and/or a block of the flowcharts and/or the block diagrams may be implemented by computer program instructions. These computer program instructions may be provided to a general-purpose computer, a dedicated computer, an embedded processor, or a processor of another programmable data processing device to generate a machine so that the instructions executable by a computer or a processor of another programmable data processing device generate an apparatus for implementing functions designated in one or more flows of the flowcharts and/or one or more blocks of the block diagrams.

Further, these computer program instructions may also be stored in a computer readable memory that can direct a computer or another programmable data processing device to work in a particular manner so that the instructions stored in the computer readable memory generate a product including an instruction apparatus and the instruction apparatus can implement functions designated in one or more flows of the flowcharts and/or one or more blocks of the block diagrams.

The computer program instructions may also be loaded on a computer or another programmable data processing device, so that a series of operation steps can be executed on the computer or another programmable device to generate processing achieved by the computer, and thus instructions executable on the computer or another programmable device are provided for steps for realizing functions designated in one or more flows of the flowcharts and/or one or more blocks of the block diagrams.

The foregoing descriptions are only examples of the present disclosure but not intended to limit the present disclosure. For the persons skilled in the art, various modifications and changes may be made to the present disclosure. Any modifications, equivalent substitutions, and improvements made within the spirit and principles of the disclosure shall be encompassed in the scope of protection of the present disclosure.

**Claims**

1. A method for controlling a rotation speed of a fan, applied to a network device, wherein the network device comprises a plurality of fans; when the network device is in a to-be-adjusted state, the method comprises:

    determining (101) an initial fan duty cycle currently used by each fan;
    based on a target sequence of the plurality of fans, sequentially traversing out (102) each fan as a candidate fan;
    performing (103) a plurality of adjustments on the initial fan duty cycle corresponding to the candidate fan to obtain a plurality of different candidate fan duty cycles;
    for each candidate fan duty cycle, obtaining reward data of the network device under the candidate fan duty cycle, and based on the reward data, determining a reward parameter value corresponding to the candidate fan duty cycle;
    selecting an optimal reward parameter value from the reward parameter values corresponding to the plurality of candidate fan duty cycles, and determining the candidate fan duty cycle corresponding to the optimal reward parameter value as a target fan duty cycle corresponding to the candidate fan; and

after the target fan duty cycle corresponding to each fan is obtained, if the network device is in a stable state, controlling (104) the fan based on the rotation speed corresponding to the target fan duty cycle corresponding to each fan.

2. The method of claim 1, wherein, after obtaining the target fan duty cycle corresponding to each fan, the method further comprises: if the network device is in the to-be-adjusted state, updating the initial fan duty cycle corresponding to each fan with the target fan duty cycle corresponding to the fan, and returning to perform the operation of, based on the target sequence of the plurality of fans, sequentially traversing out each fan as a candidate fan;

wherein, if a total number of the fans satisfying target conditions is not less than a preset threshold, it is determined that the network device is in the stable state, otherwise, it is determined that the network device is in the to-be-adjusted state; and

for each fan, if the target fan duty cycle corresponding to the fan is identical to the initial fan duty cycle corresponding to the fan, the fan satisfies the target conditions, otherwise, the fan does not satisfy the target conditions.

3. The method of claim 1, wherein,
based on the reward data, determining the reward parameter value corresponding to the candidate fan duty cycle comprises:

based on the reward data, determining a total system power and a fan duty cycle maximum value; wherein the reward data comprises the fan duty cycle corresponding to each fan, and the fan duty cycle maximum value is a maximum value of all the fan duty cycles; if the reward data comprises a power of an electrical source, determining the total system power based on the power of the electrical source; and if the reward data comprises a power corresponding to each board and a power corresponding to each fan, determining the total system power based on the powers corresponding to all the boards and the powers corresponding to all the fans;
based on the fan duty cycle maximum value, determining a target noise value;
based on the total system power and a first weight coefficient corresponding to the total system power, the target noise value and a second weight coefficient corresponding to the target noise value, determining the reward parameter value.

4. The method of claim 3, wherein,

a sum of the first weight coefficient and the second weight coefficient is a fixed value;
if energy saving is more important than noise reduction, the first weight coefficient is greater than the second weight coefficient;
if the noise reduction is more important than the energy saving, the first weight coefficient is less than the second weight coefficient.

5. The method of claim 1, wherein after the network device is powered on for startup or the network device gives out a temperature alarm, the method further comprises:

based on a temperature value of each board of the network device, determining a to-be-adjusted fan duty cycle corresponding to each fan; wherein, when each fan is controlled based on the rotation speed corresponding to the to-be-adjusted fan duty cycle corresponding to the fan, it is enabled that an absolute value of a difference between the temperature value of each board and a target temperature value is less than a temperature threshold;
after the absolute value of the difference between the temperature value of each board and the target temperature value is less than the temperature threshold, determining the network device is in the to-be-adjusted state, updating the initial fan duty cycle corresponding to each fan with the to-be-adjusted fan duty cycle corresponding to the fan, and based on the rotation speed corresponding to the initial fan duty cycle corresponding to each fan, controlling the fan.

6. The method of claim 1, wherein, in response to that the network device is in the stable state, the method further comprises:

obtaining detected state data corresponding to the network device;
inputting the detected state data to a trained target action model to obtain an output fan duty cycle corresponding to each fan; wherein different fans correspond to different output fan duty cycles or a same output fan duty cycle;
based on the reward data of the network device under the output fan duty cycle corresponding to each fan, determining a first reward parameter value corresponding to the output fan duty cycles; based on the reward data of the network device under the target fan duty cycle corresponding to each fan, determining a second reward parameter value corresponding to the target fan duty cycles;

if the first reward parameter value is superior to the second reward parameter value, determining the network device is in the to-be-adjusted state, updating the initial fan duty cycle corresponding to each fan with the output fan duty cycle corresponding to the fan, and returning to perform the operation of, based on the target sequence of the plurality of fans, sequentially traversing out each fan as a candidate fan.

7. The method of claim 6, wherein,

the detected state data corresponding to the network device comprises: sensor data corresponding to each board in the network device, system data corresponding to the network device, and the target fan duty cycle corresponding to each fan;
wherein the sensor data corresponding to each board comprises at least one of: junction temperature data corresponding to chips in the board, a maximum temperature corresponding to each temperature measuring point in the board, and a power corresponding to the board; and the system data comprises at least one of: an ambient temperature, a power of an electrical source, and a power corresponding to each fan.

8. The method of claim 6, wherein before the detected state data is input to the trained target action model, a training process of the target action model comprises:

in response to that the network device is in the stable state, obtaining sample state data corresponding to the network device;
inputting the sample state data to an initial action model to obtain a sample fan duty cycle corresponding to each fan; and, inputting the sample state data and the sample fan duty cycle corresponding to each fan to an initial evaluation model to obtain an state action value corresponding to the sample state data;
based on the sample state data, determining a reward parameter value corresponding to the state action value;
based on the reward parameter value and the state action value, training the initial action model and the initial evaluation model to obtain a trained target action model and target evaluation model.

9. The method of claim 8, wherein,
based on the reward parameter value and the state action value, training the initial action model and the initial evaluation model to obtain the trained target action model and target evaluation model, comprises:

based on the state action value, determining a first error value corresponding to the initial action model, and based on the first error value, adjusting network parameters of the initial action model to obtain an adjusted action model; based on the reward parameter value and the state action value, determining a second error value corresponding to the initial evaluation model, and based on the second error value, adjusting network parameters of the initial evaluation model to obtain an adjusted evaluation model;
if the adjusted action model and the adjusted evaluation model have converged, determining the adjusted action model as the target action model and the adjusted evaluation model as the target evaluation model;
if the adjusted action model and/or the adjusted evaluation model have not converged, determining the adjusted action model as the initial action model and the adjusted evaluation model as the initial evaluation model and returning to perform the operation of inputting the sample state data to the initial action model.

10. An apparatus for controlling a rotation speed of a fan (40), applied to a network device, wherein the network device comprises a plurality of fans; when the network device is in a to-be-adjusted state, the apparatus (40) comprises:

a determining module (41), configured to determine an initial fan duty cycle currently used by each fan;
a processing module (42), configured to, based on a target sequence of the plurality of fans, sequentially traverse out each fan as a candidate fan; perform a plurality of adjustments on the initial fan duty cycle corresponding to the candidate fan to obtain a plurality of different candidate fan duty cycles; for each candidate fan duty cycle, obtain reward data of the network device under the candidate fan duty cycle, and based on the reward data, determine a reward parameter value corresponding to the candidate fan duty cycle; select an optimal reward parameter value from the reward parameter values corresponding to the plurality of candidate fan duty cycles, and determine the candidate fan duty cycle corresponding to the optimal reward parameter value as a target fan duty cycle corresponding to the candidate fan; and
a controlling module (43), configured to, after the target fan duty cycle corresponding to each fan is obtained, if the network device is in a stable state, control the fan based on the rotation speed corresponding to the target fan duty cycle corresponding to each fan.

11. The apparatus (40) of claim 10, wherein, after obtaining the target fan duty cycle corresponding to each fan, the processing module (42) is further configured to: if the network device is in the to-be-adjusted state, update the initial fan duty cycle corresponding to each fan with the target fan duty cycle corresponding to the fan, and return to perform the operation of, based on the target sequence of the plurality of fans, sequentially traverse out each fan as a candidate fan;

> wherein, if a total number of the fans satisfying target conditions is not less than a preset threshold, it is determined that the network device is in the stable state, otherwise, it is determined that the network device is in the to-be-adjusted state; for each fan, if the target fan duty cycle corresponding to the fan is identical to the initial fan duty cycle corresponding to the fan, the fan satisfies the target conditions, otherwise, the fan does not satisfy the target conditions.

12. The apparatus (40) of claim 10, wherein, when determining the reward parameter value corresponding to the candidate fan duty cycle based on the reward data, the processing module (42) is specifically configured to:

> based on the reward data, determine a total system power and a fan duty cycle maximum value; wherein the reward data comprises the fan duty cycle corresponding to each fan, and the fan duty cycle maximum value is a maximum value of all the fan duty cycles; if the reward data comprises a power of an electrical source, determine the total system power based on the power of the electrical source; and if the reward data comprises a power corresponding to each board and a power corresponding to each fan, determine the total system power based on the powers corresponding to all the boards and the powers corresponding to all the fans; based on the fan duty cycle maximum value, determine a target noise value; based on the total system power and a first weight coefficient corresponding to the total system power, the target noise value and a second weight coefficient corresponding to the target noise value, determine the reward parameter value.

13. The apparatus (40) of claim 10, wherein,

> after the network device is powered on for startup or the network device gives out a temperature alarm, the determining module is further configured to: based on a temperature value of each board of the network device, determine a to-be-adjusted fan duty cycle corresponding to each fan; wherein, when each fan is controlled based on the rotation speed corresponding to the to-be-adjusted fan duty cycle corresponding to the fan, it is enabled that an absolute value of a difference between the temperature value of each board and a target temperature value is less than a temperature threshold; the determining module is further configured to: after the absolute value of the difference between the temperature value of each board and the target temperature value is less than the temperature threshold, determine the network device is in the to-be-adjusted state, update the initial fan duty cycle corresponding to each fan with the to-be-adjusted fan duty cycle corresponding to the fan; and the controlling module is further configured to, based on the rotation speed corresponding to the initial fan duty cycle corresponding to each fan, control the fan.

14. The apparatus (40) of claim 10, wherein, in response to that the network device is in the stable state, the processing module is further configured to: obtain detected state data corresponding to the network device;

> input the detected state data to a trained target action model to obtain an output fan duty cycle corresponding to each fan; wherein different fans correspond to different output fan duty cycles or a same output fan duty cycle; based on the reward values of the network device under the output fan duty cycle corresponding to each fan, determine a first reward parameter value corresponding to the output fan duty cycles; based on the reward data of the network device under the target fan duty cycle corresponding to each fan, determine a second reward parameter value corresponding to the target fan duty cycles; if the first reward parameter value is superior to the second reward parameter value, determine the network device is in the to-be-adjusted state, update the initial fan duty cycle corresponding to each fan with the output fan duty cycle corresponding to the fan, and return to perform the operation of, based on the target sequence of the plurality of fans, sequentially traversing out each fan as a candidate fan.

15. A machine readable storage medium, wherein the machine readable storage medium stores machine executable instructions executable by a processor; the processor is configured to execute the machine executable instructions to perform the steps of the method of any one of claims 1 to 9.

**Patentansprüche**

1. Verfahren zum Steuern einer Drehgeschwindigkeit eines Gebläses, das bei einer Netzwerkeinrichtung eingesetzt wird, wobei die Netzwerkeinrichtung eine Vielzahl von Gebläsen umfasst und das Verfahren, wenn sich die Netzwerkeinrichtung in einem anzupassenden Zustand befindet, umfasst:

   Bestimmen (101) einer von jedem Gebläse aktuell genutzten Anfangs-Gebläse-Einschaltdauer;
   Durchlaufen (102) jedes Gebläses als ein mögliches Gebläse auf Basis einer Ziel-Sequenz der Vielzahl von Gebläsen;
   Durchführen (103) einer Vielzahl von Anpassungen an der die möglichen Gebläse entsprechenden Anfangs-Gebläse-Einschaltdauer zum Ermitteln einer Vielzahl verschiedener möglicher Gebläse-Einschaltdauern;
   Ermitteln von Vorteil-Daten der Netzwerkeinrichtung für jede mögliche Gebläse-Einschaltdauer bei der möglichen Gebläse-Einschaltdauer und Bestimmen eines der möglichen Gebläse-Einschaltdauer entsprechenden Vorteil-Parameterwertes auf Basis der Vorteil-Daten;
   Auswählen eines optimalen Vorteil-Parameterwertes aus den der Vielzahl möglicher Gebläse-Einschaltdauern entsprechenden Vorteil-Parameterwerten und Bestimmen der dem optimalen Vorteil-Parameterwert entsprechenden möglichen Gebläse-Einschaltdauer als eine dem möglichen Gebläse entsprechende Ziel-Gebläse-Einschaltdauer; sowie
   Steuern (104) des Gebläses auf Basis der Drehgeschwindigkeit, die der jedem Gebläse entsprechenden Ziel-Gebläse-Einschaltdauer entspricht, nachdem die jedem Gebläse entsprechende Ziel-Gebläse-Einschaltdauer ermittelt ist, wenn sich die Netzwerkeinrichtung in einem stabilen Zustand befindet.

2. Verfahren nach Anspruch 1, wobei das Verfahren nach Ermitteln der jedem Gebläse entsprechenden Ziel-Gebläse-Einschaltdauer des Weiteren umfasst:

   Aktualisieren der jedem Gebläse entsprechenden Anfangs-Gebläse-Einschaltdauer mit der dem Gebläse entsprechenden Ziel-Gebläse-Einschaltdauer, wenn die Netzwerkeinrichtung sich in dem anzupassenden Zustand befindet, und Zurückkehren zum Durchführen des Vorgangs, in dem auf Basis der Ziel-Sequenz der Vielzahl von Gebläsen jedes Gebläse als ein mögliches Gebläse sequenziell durchlaufen wird;
   wobei, wenn eine Gesamtzahl der Gebläse, die Ziel-Bedingungen erfüllen, nicht unter einem vorgegebenen Schwellenwert liegt, festgestellt wird, dass sich die Netzwerkeinrichtung in dem stabilen Zustand befindet und ansonsten festgestellt wird, dass sich die Netzwerkeinrichtung in dem anzupassenden Zustand befindet; und für jedes Gebläse, wenn die dem Gebläse entsprechende Ziel-Gebläse-Einschaltdauer identisch mit der dem Gebläse entsprechenden Anfangs-Gebläse-Einschaltdauer ist, das Gebläse die Ziel-Bedingungen erfüllt und ansonsten das Gebläse die Ziel-Bedingungen nicht erfüllt.

3. Verfahren nach Anspruch 1, wobei
   Bestimmen des der möglichen Gebläse-Einschaltdauer entsprechenden Vorteil-Parameterwertes auf Basis der Vorteil-Daten umfasst:

   Bestimmen einer Gesamt-Systemleistung sowie eines Maximalwertes der Gebläse-Einschaltdauer auf Basis der Vorteil-Daten; wobei die Vorteil-Daten die jedem Gebläse entsprechende Gebläse-Einschaltdauer umfassen und der Maximalwert der Gebläse-Einschaltdauer ein Maximalwert aller Gebläse-Einschaltdauern ist; Bestimmen der Gesamt-Systemleistung auf Basis der Leistung einer Stromquelle, wenn die Vorteil-Daten die Leistung der Stromquelle umfassen, und Bestimmen einer Gesamt-Systemleistung auf Basis allen der Platinen entsprechender Leistungswerte sowie allen der Gebläse entsprechender Leistungswerte, wenn die Vorteil-Daten die jeder Platine entsprechende Leistung sowie die jedem Gebläse entsprechende Leistung umfassen;
   Bestimmen eines Ziel-Rauschwertes auf Basis des Maximalwertes der Gebläse-Einschaltdauer;
   Bestimmen des Vorteil-Parameterwertes auf Basis der Gesamt-Systemleistung sowie eines der Gesamt-Systemleistung entsprechenden ersten Gewicht-Koeffizienten, des Ziel-Rauschwertes sowie eines dem Ziel-Rauschwert entsprechenden zweiten Gewicht-Koeffizienten.

4. Verfahren nach Anspruch 3, wobei

   eine Summe aus dem ersten Gewicht-Koeffizienten und dem zweiten Gewicht-Koeffizienten ein fester Wert ist;
   der erste Gewicht-Koeffizient größer ist als der zweite Gewicht-Koeffizient, wenn Energieeinsparung wichtiger ist als Rauschminderung;
   der erste Gewicht-Koeffizient kleiner ist als der zweite Gewicht-Koeffizient, wenn die Rauschminderung wichtiger ist als die Energieeinsparung.

5. Verfahren nach Anspruch 1, wobei, nachdem der Netzwerkeinrichtung Strom zum Starten zugeführt wird oder die Netzwerkeinrichtung eine Temperaturwarnung ausgibt, das Verfahren des Weiteren umfasst:

Bestimmen einer jedem Gebläse entsprechenden anzupassenden Gebläse-Einschaltdauer auf Basis eines Temperaturwertes jeder Platine der Netzwerkeinrichtung;

wobei, wenn jedes Gebläse auf Basis der Drehgeschwindigkeit gesteuert wird, die der dem Gebläse entsprechenden Gebläse-Laufzeit entspricht, ermöglicht wird, dass ein Absolutwert einer Differenz zwischen dem Temperaturwert jeder Platine und einem Ziel-Temperaturwert unter einem vorgegebenen Temperatur-Schwellenwert liegt;

nachdem der Absolutwert der Differenz zwischen dem Temperaturwert jeder Platine und dem Ziel-Temperaturwert unter dem Temperatur-Schwellenwert liegt, Feststellen, dass sich die Netzwerkeinrichtung in dem anzupassenden Zustand befindet, Aktualisieren der jedem Gebläse entsprechenden Anfangs-Gebläse-Einschaltdauer mit der dem Gebläse entsprechenden anzupassenden Gebläse-Einschaltdauer,

sowie Steuern des Gebläses auf Basis der Drehgeschwindigkeit, die der jedem Gebläse entsprechenden Anfangs-Gebläse-Einschaltdauer entspricht.

6. Verfahren nach Anspruch 1, wobei das Verfahren des Weiteren in Reaktion darauf, dass sich die Netzwerkeinrichtung in dem stabilen Zustand befindet, umfasst:

Ermitteln der Netzwerkeinrichtung entsprechender Erfassungszustand-Daten;

Eingeben der Erfassungszustands-Daten in ein trainiertes Ziel-Aktionsmodell zum Ermitteln einer jedem Gebläse entsprechenden Ausgangs-Gebläse-Einschaltdauer;

wobei verschiedene Gebläse verschiedenen Ausgangs-Gebläse-Einschaltdauern oder ein und derselben Ausgangs-Gebläse-Einschaltdauer entsprechen;

Bestimmen eines den Ausgangs-Gebläse-Einschaltdauern entsprechenden ersten Vorteil-Parameterwertes auf Basis der Vorteil-Daten der Netzwerkeinrichtung in der jedem Gebläse entsprechenden Ausgangs-Gebläse-Einschaltdauer; Bestimmen eines den Ziel-Gebläse-Einschaltdauern entsprechenden zweiten Vorteil-Parameterwertes auf Basis der Vorteil-Daten der Netzwerkeinrichtung in der jedem Gebläse entsprechenden Ziel-Gebläse-Einschaltdauer;

Feststellen, dass sich die Netzwerkeinrichtung in dem anzupassenden Zustand befindet, Aktualisieren der jedem Gebläse entsprechenden Anfangs-Gebläse-Einschaltdauer mit der dem Gebläse entsprechenden Ausgangs-Gebläse-Einschaltdauer, wenn der erste Vorteil-Parameterwert über dem zweiten Vorteil-Parameterwert liegt, und Zurückkehren zum Durchführen des Vorgangs, in dem auf Basis der Ziel-Sequenz der Vielzahl von Gebläsen jedes Gebläse als ein mögliches Gebläse sequenziell durchlaufen wird.

7. Verfahren nach Anspruch 6, wobei

die der Netzwerkeinrichtung entsprechenden Erfassungszustands-Daten jeder Platine in der Netzwerkeinrichtung entsprechende Sensor-Daten, der Netzwerkeinrichtung entsprechende System-Daten sowie die jedem Gebläse entsprechende Ziel-Gebläse-Einschaltdauer umfassen;

wobei die jeder Platine entsprechenden Sensor-Daten Kontakttemperatur-Daten, die Chips an der Platine entsprechen, eine maximale Temperatur, die jedem Temperatur-Messpunkt an der Platine entspricht, oder/und eine der Platine entsprechende Leistung umfassen und die System-Daten eine Umgebungstemperatur, eine Leistung einer Stromquelle oder/und eine jedem Gebläse entsprechende Leistung umfassen.

8. Verfahren nach Anspruch 6, wobei, bevor die Erfassungszustands-Daten in das trainierte Ziel-Aktionsmodell eingegeben werden, ein Prozess zum Trainieren des Ziel-Aktionsmodells umfasst:

Ermitteln der Netzwerkeinrichtung entsprechender Abtastzustands-Daten in Reaktion darauf, dass sich die Netzwerkeinrichtung in dem stabilen Zustand befindet;

Eingeben der Abtastzustands-Daten in ein Anfangs-Aktionsmodell zum Ermitteln einer jedem Gebläse entsprechenden Abtast-Gebläse-Einschaltdauer; und Eingeben der Abtastzustands-Daten sowie der jedem Gebläse entsprechenden Abtast-Gebläse-Einschaltdauer in ein Anfangs-Bewertungsmodell zum Ermitteln eines den Abtastzustands-Daten entsprechenden Zustands-Aktionswertes;

Bestimmen eines dem Zustands-Aktionswert entsprechenden Vorteil-Parameterwertes auf Basis der Abtastzustands-Daten;

Trainieren des Anfangs-Aktionsmodells sowie des Anfangs-Bewertungsmodells auf Basis des Vorteil-Parameterwertes und des Zustands-Aktionswertes zum Ermitteln eines trainierten Ziel-Aktionsmodells sowie eines Ziel-Bewertungsmodells.

9.  Verfahren nach Anspruch 8, wobei
    Trainieren des Anfangs-Aktionsmodells sowie des Anfangs-Bewertungsmodells auf Basis des Vorteil-Parameterwertes und des Zustands-Aktionswertes zum Ermitteln des trainierten Ziel-Aktionsmodells sowie des Ziel-Bewertungsmodells umfasst:

    Bestimmen eines dem Anfangs-Aktionsmodell entsprechenden ersten Fehlerwertes auf Basis des Zustands-Aktionswertes und Anpassen von Netzwerk-Parametern des Anfangs-Aktionsmodells auf Basis des ersten Fehlerwertes zum Ermitteln eines angepassten Aktionsmodells; Bestimmen eines dem Anfangs-Bewertungsmodell entsprechenden zweiten Fehlerwertes auf Basis des Vorteil-Parameterwertes sowie des Zustands-Aktionswertes und Anpassen von Netzwerk-Parametern des Anfangs-Bewertungsmodells auf Basis des zweiten Fehlerwertes zum Ermitteln eines angepassten Bewertungsmodells; Bestimmen des angepassten Aktionsmodells als das Ziel-Aktionsmodell und des angepassten Bewertungsmodells als das Ziel-Bewertungsmodell, wenn das angepasste Aktionsmodell und das angepasste Bewertungsmodell konvergiert sind; Bestimmen des angepassten Aktionsmodells als das Anfangs-Aktionsmodell und des angepassten Bewertungsmodells als das Anfangs-Bewertungsmodell sowie Zurückkehren zum Durchführen des Vorgangs zum Eingeben der Abtastzustands-Daten in das Anfangs-Aktionsmodell, wenn das angepasste Aktionsmodell und/oder das angepasste Bewertungsmodell nicht konvergiert sind.

10. Vorrichtung zum Steuern einer Drehgeschwindigkeit eines Gebläses (40), das bei einer Netzwerkeinrichtung eingesetzt wird, wobei die Netzwerkeinrichtung eine Vielzahl von Gebläsen umfasst und die Vorrichtung (40), wenn sich die Netzwerkeinrichtung in einem zu regulierenden Zustand befindet, umfasst:

    ein Bestimmungs-Modul (41), das so ausgeführt ist, dass es eine von jedem Gebläse aktuell genutzte Anfangs-Gebläse-Einschaltdauer bestimmt; ein Verarbeitungs-Modul (42), das so ausgeführt ist, dass es auf Basis einer Ziel-Sequenz der Vielzahl von Gebläsen sequenziell jedes Gebläse als ein mögliches Gebläse durchläuft, eine Vielzahl von Anpassungen an der dem möglichen Gebläse entsprechenden Anfangs-Gebläse-Einschaltdauer durchführt, um eine Vielzahl unterschiedlicher möglicher Gebläse-Einschaltdauern zu ermitteln; Vorteil-Daten der Netzwerkeinrichtung in der möglichen Gebläse-Einschaltdauer ermittelt und einen der möglichen Gebläse-Einschaltdauer entsprechenden Vorteil-Parameterwert auf Basis der Vorteil-Daten bestimmt; einen optimalen Vorteil-Parameterwert aus den der Vielzahl möglicher Gebläse-Einschaltdauern entsprechenden Vorteil-Parameterwerten auswählt und die dem optimalen Vorteil-Parameterwert entsprechende mögliche Gebläse-Einschaltdauer als eine dem möglichen Gebläse entsprechende Ziel-Gebläse-Einschaltdauer bestimmt; sowie
    ein Steuerungs-Modul (43), das so ausgeführt ist, dass es, nachdem die jedem Gebläse entsprechende Ziel-Gebläse-Einschaltdauer ermittelt ist, das Gebläse, wenn sich die Netzwerkeinrichtung in einem stabilen Zustand befindet, auf Basis der Drehgeschwindigkeit steuert, die der jedem Gebläse entsprechenden Ziel-Gebläse-Einschaltdauer entspricht.

11. Vorrichtung (40) nach Anspruch 10, wobei das Verarbeitungs-Modul (42) des Weiteren so ausgeführt ist, dass es nach Ermitteln der jedem Gebläse entsprechenden Ziel-Gebläse-Einschaltdauer die jedem Gebläse entsprechende Anfangs-Gebläse-Einschaltdauer mit der dem Gebläse entsprechenden Ziel-Gebläse-Einschaltdauer aktualisiert, wenn die Netzwerkeinrichtung sich in dem anzupassenden Zustand befindet, und zum Durchführen des Vorgangs zurückkehrt, in dem auf Basis der Ziel-Sequenz der Vielzahl von Gebläsen jedes Gebläse als ein mögliches Gebläse sequenziell durchlaufen wird;

    wobei, wenn eine Gesamtzahl der Gebläse, die Ziel-Bedingungen erfüllen, nicht unter einem vorgegebenen Schwellenwert liegt, festgestellt wird, dass sich die Netzwerkeinrichtung in dem stabilen Zustand befindet und ansonsten festgestellt wird, dass sich die Netzwerkeinrichtung in dem anzupassenden Zustand befindet; und für jedes Gebläse, wenn die dem Gebläse entsprechende Ziel-Gebläse-Einschaltdauer identisch mit der dem Gebläse entsprechenden Anfangs-Gebläse-Einschaltdauer ist, das Gebläse die Ziel-Bedingungen erfüllt und ansonsten das Gebläse die Ziel-Bedingungen nicht erfüllt.

12. Vorrichtung (40) nach Anspruch 10, wobei das Verarbeitungs-Modul (42) beim Bestimmen des der möglichen Gebläse-Einschaltdauer entsprechenden Vorteil-Parameterwertes auf Basis der Vorteil-Daten insbesondere so ausgeführt ist, dass es:

    eine Gesamt-Systemleistung sowie einen Maximalwert der Gebläse-Einschaltdauer auf Basis der Vorteil-Daten bestimmt, wobei die Vorteil-Daten die jedem Gebläse entsprechende Gebläse-Einschaltdauer umfassen und der Maximalwert der Gebläse-Einschaltdauer ein Maximalwert aller Gebläse-Einschaltdauern ist; die Gesamt-Systemleistung auf Basis der Leistung einer Stromquelle bestimmt, wenn die Vorteil-Daten eine Leistung der Stromquelle umfassen, und die Gesamt-Systemleistung auf Basis der allen der Platinen entsprechenden Leistungswerte sowie der allen der Gebläse entsprechenden Leistungswerte bestimmt, wenn die Vorteil-Daten eine jeder Platine entsprechende Leistung sowie eine jedem Gebläse entsprechende Leistung umfassen;
einen Ziel-Rauschwert auf Basis des Maximalwertes der Gebläse-Einschaltdauer bestimmt; den Vorteil-Parameterwert auf Basis der Gesamt-Systemleistung sowie eines der Gesamt-Systemleistung entsprechenden ersten Gewicht-Koeffizienten, des Ziel-Rauschwertes sowie eines dem Ziel-Rauschwert entsprechenden zweiten Gewicht-Koeffizienten bestimmt.

13. Vorrichtung (40) nach Anspruch 10, wobei

das Bestimmungs-Modul des Weiteren so ausgeführt ist, dass es, nachdem der Netzwerkeinrichtung Strom zum Starten zugeführt wird oder die Netzwerkeinrichtung eine Temperaturwarnung ausgibt, eine jedem Gebläse entsprechende anzupassende Gebläse-Einschaltdauer auf Basis eines Temperaturwertes jeder Platine der Netzwerkeinrichtung bestimmt; wobei, wenn jedes Gebläse auf Basis der Drehgeschwindigkeit gesteuert wird, die der dem Gebläse entsprechenden anzupassenden Gebläse-Laufzeit entspricht, ermöglicht wird, dass ein Absolutwert einer Differenz zwischen dem Temperaturwert jeder Platine und einem Ziel-Temperaturwert unter einem Temperatur-Schwellenwert liegt;
das Bestimmungs-Modul des Weiteren so ausgeführt ist, dass es nachdem der Absolutwert der Differenz zwischen dem Temperaturwert jeder Platine und der Ziel-Temperatur unter dem Temperatur-Schwellenwert liegt, feststellt, dass sich die Netzwerkeinrichtung in dem anzupassenden Zustand befindet, die jedem Gebläse entsprechende Anfangs-Gebläse-Einschaltdauer mit der dem Gebläse entsprechenden anzupassenden Gebläse-Einschaltdauer aktualisiert, und das Steuerungs-Modul des Weiteren so ausgeführt ist, dass es das Gebläse auf Basis der Drehgeschwindigkeit steuert, die der jedem Gebläse entsprechenden Anfangs-Gebläse-Einschaltdauer entspricht.

14. Vorrichtung (40) nach Anspruch 10, wobei das Verarbeitungs-Modul des Weiteren so ausgeführt ist, dass es in Reaktion darauf, dass sich die Netzwerkeinrichtung in dem stabilen Zustand befindet, der Netzwerkeinrichtung entsprechende Erfassungszustands-Daten ermittelt;

die Erfassungszustands-Daten in ein trainiertes Ziel-Aktionsmodell eingibt, um eine jedem Gebläse entsprechende Ausgangs-Gebläse-Einschaltdauer zu ermitteln; wobei verschiedene Gebläse verschiedenen Ausgangs-Gebläse-Einschaltdauern oder ein und derselben Ausgangs-Gebläse-Einschaltdauer entsprechen; einen den Ausgangs-Gebläse-Einschaltdauern entsprechenden ersten Vorteil-Parameterwert auf Basis der Vorteil-Daten der Netzwerkeinrichtung in der jedem Gebläse entsprechenden Ausgangs-Gebläse-Einschaltdauer bestimmt, und; einen den Ziel-Gebläse-Einschaltdauern entsprechenden zweiten Vorteil-Parameterwert auf Basis der Vorteil-Daten der Netzwerkeinrichtung in der jedem Gebläse entsprechenden Ziel-Gebläse-Einschaltdauer bestimmt; feststellt, dass sich die Netzwerkeinrichtung in dem anzupassenden Zustand befindet, wenn der erste Vorteil-Parameterwert über dem zweiten Vorteil-Parameterwert liegt, die jedem Gebläse entsprechende Anfangs-Gebläse-Einschaltdauer mit der dem Gebläse entsprechenden Ausgangs-Gebläse-Einschaltdauer aktualisiert, und zum Durchführen des Vorgangs zurückkehrt, in dem auf Basis der Ziel-Sequenz der Vielzahl von Gebläsen jedes Gebläse als ein mögliches Gebläse sequenziell durchlaufen wird.

15. Maschinenlesbares Speichermedium, wobei das maschinenlesbare Speichermedium maschinenausführbare Anweisungen speichert die von einem Prozessor ausgeführt werden können, und der Prozessor zum Ausführen von Anweisungen zum Durchführen des Verfahrens nach einem der Ansprüche 1 bis 9 konfiguriert ist.

**Revendications**

1. Procédé pour commander une vitesse de rotation d'un ventilateur, appliqué à un dispositif de réseau, dans lequel le dispositif de réseau comprend une pluralité de ventilateurs ; lorsque le dispositif de réseau est dans un état dans lequel il doit être réglé, le procédé comprend :

la détermination (101) d'un rapport cyclique de ventilateur initial qui est utilisé présentement par chaque ventilateur ;
sur la base d'une séquence cible de la pluralité de ventilateurs, la considération de façon séquentielle (102) de chaque ventilateur en tant que ventilateur candidat ;

la réalisation (103) d'une pluralité de réglages sur le rapport cyclique de ventilateur initial qui correspond au ventilateur candidat pour obtenir une pluralité de rapports cycliques de ventilateur candidat différents ;

pour chaque rapport cyclique de ventilateur candidat, l'obtention de données de récompense du dispositif de réseau sous le rapport cyclique de ventilateur candidat et, sur la base des données de récompense, la détermination d'une valeur de paramètre de récompense qui correspond au rapport cyclique de ventilateur candidat ;

la sélection d'une valeur de paramètre de récompense optimum parmi les valeurs de paramètre de récompense qui correspondent à la pluralité de rapports cycliques de ventilateur candidat et la détermination du rapport cyclique de ventilateur candidat qui correspond à la valeur de paramètre de récompense optimum en tant que rapport cyclique de ventilateur cible qui correspond au ventilateur candidat ; et

après que le rapport cyclique de ventilateur cible qui correspond à chaque ventilateur a été obtenu, si le dispositif de réseau est dans un état stable, la commande (104) du ventilateur sur la base de la vitesse de rotation qui correspond au rapport cyclique de ventilateur cible qui correspond à chaque ventilateur.

2. Procédé selon la revendication 1, dans lequel :
après l'obtention du rapport cyclique de ventilateur cible qui correspond à chaque ventilateur, le procédé comprend en outre : si le dispositif de réseau est dans l'état dans lequel il doit être réglé, la mise à jour du rapport cyclique de ventilateur initial qui correspond à chaque ventilateur à l'aide du rapport cyclique de ventilateur cible qui correspond au ventilateur, et le retour à la réalisation, sur la base de la séquence cible de la pluralité de ventilateurs, de l'opération consistant à considérer de façon séquentielle chaque ventilateur en tant que ventilateur candidat ; dans lequel :

si un nombre total des ventilateurs qui satisfont des conditions cibles n'est pas inférieur à un seuil prédéfini, il est déterminé que le dispositif de réseau est dans l'état stable et sinon, il est déterminé que le dispositif de réseau est dans l'état dans lequel il doit être réglé ; et dans lequel :
pour chaque ventilateur, si le rapport cyclique de ventilateur cible qui correspond au ventilateur est identique au rapport cyclique de ventilateur initial qui correspond au ventilateur, le ventilateur satisfait les conditions cibles et sinon, le ventilateur ne satisfait pas les conditions cibles.

3. Procédé selon la revendication 1, dans lequel :

sur la base des données de récompense, la détermination de la valeur de paramètre de récompense qui correspond au rapport cyclique de ventilateur candidat comprend :

sur la base des données de récompense, la détermination d'une puissance système totale et d'une valeur maximum de rapport cyclique de ventilateur ; dans lequel les données de récompense comprennent le rapport cyclique de ventilateur qui correspond à chaque ventilateur, et la valeur maximum de rapport cyclique de ventilateur est une valeur maximum de tous les rapports cycliques de ventilateur ; si les données de récompense comprennent une puissance d'une source électrique, la détermination de la puissance système totale sur la base de la puissance de la source électrique ; et si les données de récompense comprennent une puissance qui correspond à chaque carte et une puissance qui correspond à chaque ventilateur, la détermination de la puissance système totale sur la base des puissances qui correspondent à toutes les cartes et des puissances qui correspondent à tous les ventilateurs ;

sur la base de la valeur maximum de rapport cyclique de ventilateur, la détermination d'une valeur de bruit cible ; et

sur la base de la puissance système totale et d'un premier coefficient de pondération qui correspond à la puissance système totale, de la valeur de bruit cible et d'un second coefficient de pondération qui correspond à la valeur de bruit cible, la détermination de la valeur de paramètre de récompense.

4. Procédé selon la revendication 3, dans lequel :

une somme du premier coefficient de pondération et du second coefficient de pondération est une valeur fixe ;

si l'économie d'énergie est plus importante que la réduction du bruit, le premier coefficient de pondération est supérieur au second coefficient de pondération ; et

si la réduction du bruit est plus importante que l'économie d'énergie, le premier coefficient de pondération est inférieur au second coefficient de pondération.

5. Procédé selon la revendication 1, dans lequel, après que le dispositif de réseau a été mis sous tension pour son démarrage ou après que le dispositif de réseau a fourni une alarme de température, le procédé comprend en outre :

sur la base d'une valeur de température de chaque carte du dispositif de réseau, la détermination d'un rapport cyclique de ventilateur qui doit être réglé qui correspond à chaque ventilateur ; dans lequel, lorsque chaque ventilateur est commandé sur la base de la vitesse de rotation qui correspond au rapport cyclique de ventilateur qui doit être réglé qui correspond au ventilateur, il est validé qu'une valeur absolue d'une différence entre la valeur de température de chaque carte et une valeur de température cible est inférieure à un seuil de température ; et après que la valeur absolue de la différence entre la valeur de température de chaque carte et la valeur de température cible est inférieure au seuil de température, la détermination du fait que le dispositif de réseau est dans l'état dans lequel il doit être réglé, la mise à jour du rapport cyclique de ventilateur initial qui correspond à chaque ventilateur à l'aide du rapport cyclique de ventilateur qui doit être réglé qui correspond au ventilateur et sur la base de la vitesse de rotation qui correspond au rapport cyclique de ventilateur initial qui correspond à chaque ventilateur, la commande du ventilateur.

**6.** Procédé selon la revendication 1, dans lequel, en réponse au fait que le dispositif de réseau est dans l'état stable, le procédé comprend en outre :

l'obtention de données d'état détecté qui correspondent au dispositif de réseau ;
l'entrée des données d'état détecté sur un modèle d'action cible appris pour obtenir un rapport cyclique de ventilateur de sortie qui correspond à chaque ventilateur ; dans lequel des ventilateurs différents correspondent à des rapports cycliques de ventilateur de sortie différents ou à un même rapport cyclique de ventilateur de sortie ;
sur la base des données de récompense du dispositif de réseau sous le rapport cyclique de ventilateur de sortie qui correspond à chaque ventilateur, la détermination d'une première valeur de paramètre de récompense qui correspond aux rapports cycliques de ventilateur de sortie ; sur la base des données de récompense du dispositif de réseau sous le rapport cyclique de ventilateur cible qui correspond à chaque ventilateur, la détermination d'une seconde valeur de paramètre de récompense qui correspond aux rapports cycliques de ventilateur cibles ; et
si la première valeur de paramètre de récompense est supérieure à la seconde valeur de paramètre de récompense, la détermination du fait que le dispositif de réseau est dans l'état dans lequel il doit être réglé, la mise à jour du rapport cyclique de ventilateur initial qui correspond à chaque ventilateur à l'aide du rapport cyclique de ventilateur de sortie qui correspond au ventilateur, et le retour à la réalisation, sur la base de la séquence cible de la pluralité de ventilateurs, de l'opération consistant à considérer de façon séquentielle chaque ventilateur en tant que ventilateur candidat.

**7.** Procédé selon la revendication 6, dans lequel :
les données d'état détecté qui correspondent au dispositif de réseau comprennent : des données de capteur qui correspondent à chaque carte dans le dispositif de réseau, des données système qui correspondent au dispositif de réseau et le rapport cyclique de ventilateur cible qui correspond à chaque ventilateur ; et dans lequel :
les données de capteur qui correspondent à chaque carte comprennent au moins une information parmi : des données de température de jonction qui correspondent à des puces dans la carte, une température maximum qui correspond à chaque point de mesure de température dans la carte et une puissance qui correspond à la carte ; et les données système comprennent au moins une information parmi : une température ambiante, une puissance d'une source électrique et une puissance qui correspond à chaque ventilateur.

**8.** Procédé selon la revendication 6, dans lequel, avant que les données d'état détecté ne soient entrées sur le modèle d'action cible appris, un processus d'apprentissage du modèle d'action cible comprend :

en réponse au fait que le dispositif de réseau est dans l'état stable, l'obtention de données d'état échantillon qui correspondent au dispositif de réseau ;
l'entrée des données d'état échantillon sur un modèle d'action initial pour obtenir un rapport cyclique de ventilateur échantillon qui correspond à chaque ventilateur ; et l'entrée des données d'état échantillon et du rapport cyclique de ventilateur échantillon qui correspondent à chaque ventilateur sur un modèle d'évaluation initial pour obtenir une valeur d'action d'état qui correspond aux données d'état échantillon ;
sur la base des données d'état échantillon, la détermination d'une valeur de paramètre de récompense qui correspond à la valeur d'action d'état ; et
sur la base de la valeur de paramètre de récompense et de la valeur d'action d'état, l'apprentissage du modèle d'action initial et du modèle d'évaluation initial pour obtenir un modèle d'action cible appris et un modèle d'évaluation cible appris.

**9.** Procédé selon la revendication 8, dans lequel :
sur la base de la valeur de paramètre de récompense et de la valeur d'action d'état, l'apprentissage du modèle d'action initial et du modèle d'évaluation initial pour obtenir le modèle d'action cible appris et le modèle d'évaluation cible appris comprend :

sur la base de la valeur d'action d'état, la détermination d'une première valeur d'erreur qui correspond au modèle d'action initial et sur la base de la première valeur d'erreur, le réglage de paramètres de réseau du modèle d'action initial pour obtenir un modèle d'action réglé ; sur la base de la valeur de paramètre de récompense et de la valeur d'action d'état, la détermination d'une seconde valeur d'erreur qui correspond au modèle d'évaluation initial, et sur la base de la seconde valeur d'erreur, le réglage de paramètres de réseau du modèle d'évaluation initial pour obtenir un modèle d'évaluation réglé ;
si le modèle d'action réglé et le modèle d'évaluation réglé ont convergé, la détermination du modèle d'action réglé en tant que modèle d'action cible et du modèle d'évaluation réglé en tant que modèle d'évaluation cible ; et
si le modèle d'action réglé et/ou le modèle d'évaluation réglé n'ont/n'a pas convergé, la détermination du modèle d'action réglé en tant que modèle d'action initial et du modèle d'évaluation réglé en tant que modèle d'évaluation initial et le retour à la réalisation de l'opération d'entrée des données d'état échantillon sur le modèle d'action initial.

10. Appareil (40) pour commander une vitesse de rotation d'un ventilateur, appliqué à un dispositif de réseau, dans lequel le dispositif de réseau comprend une pluralité de ventilateurs ; lorsque le dispositif de réseau est dans un état dans lequel il doit être réglé, l'appareil (40) comprend :

un module de détermination (41), configuré pour déterminer un rapport cyclique de ventilateur initial qui est utilisé présentement par chaque ventilateur ;
un module de traitement (42), configuré pour, sur la base d'une séquence cible de la pluralité de ventilateurs, considérer de façon séquentielle chaque ventilateur en tant que ventilateur candidat ; réaliser une pluralité de réglages sur le rapport cyclique de ventilateur initial qui correspond au ventilateur candidat pour obtenir une pluralité de rapports cycliques de ventilateur candidat différents ; pour chaque rapport cyclique de ventilateur candidat, obtenir des données de récompense du dispositif de réseau sous le rapport cyclique de ventilateur candidat et, sur la base des données de récompense, déterminer une valeur de paramètre de récompense qui correspond au rapport cyclique de ventilateur candidat ; sélectionner une valeur de paramètre de récompense optimum parmi les valeurs de paramètre de récompense qui correspondent à la pluralité de rapports cycliques de ventilateur candidat et déterminer le rapport cyclique de ventilateur candidat qui correspond à la valeur de paramètre de récompense optimum en tant que rapport cyclique de ventilateur cible qui correspond au ventilateur candidat ; et
un module de commande (43), configuré pour, après que le rapport cyclique de ventilateur cible qui correspond à chaque ventilateur a été obtenu, si le dispositif de réseau est dans un état stable, commander le ventilateur sur la base de la vitesse de rotation qui correspond au rapport cyclique de ventilateur cible qui correspond à chaque ventilateur.

11. Appareil (40) selon la revendication 10, dans lequel : après l'obtention du rapport cyclique de ventilateur cible qui correspond à chaque ventilateur, le module de traitement (42) est en outre configuré pour : si le dispositif de réseau est dans l'état dans lequel il doit être réglé, mettre à jour le rapport cyclique de ventilateur initial qui correspond à chaque ventilateur à l'aide du rapport cyclique de ventilateur cible qui correspond au ventilateur, et retourner à la réalisation, sur la base de la séquence cible de la pluralité de ventilateurs, de l'opération consistant à considérer de façon séquentielle chaque ventilateur en tant que ventilateur candidat ; dans lequel :
si un nombre total des ventilateurs qui satisfont des conditions cibles n'est pas inférieur à un seuil prédéfini, il est déterminé que le dispositif de réseau est dans l'état stable et sinon, il est déterminé que le dispositif de réseau est dans l'état dans lequel il doit être réglé ; et dans lequel :
pour chaque ventilateur, si le rapport cyclique de ventilateur cible qui correspond au ventilateur est identique au rapport cyclique de ventilateur initial qui correspond au ventilateur, le ventilateur satisfait les conditions cibles et sinon, le ventilateur ne satisfait pas les conditions cibles.

12. Appareil (40) selon la revendication 10, dans lequel, lors de la détermination de la valeur de paramètre de récompense qui correspond au rapport cyclique de ventilateur candidat sur la base des données de récompense, le module de traitement (42) est configuré de façon spécifique pour :

sur la base des données de récompense, déterminer une puissance système totale et une valeur maximum de rapport cyclique de ventilateur ; dans lequel les données de récompense comprennent le rapport cyclique de ventilateur qui correspond à chaque ventilateur, et la valeur maximum de rapport cyclique de ventilateur est une valeur maximum de tous les rapports cycliques de ventilateur ; si les données de récompense comprennent une puissance d'une source électrique, déterminer la puissance système totale sur la base de la puissance de la source électrique ; et si les données de récompense comprennent une puissance qui correspond à chaque carte et une puissance qui correspond à chaque ventilateur, déterminer la puissance système totale sur la base des puissances qui correspondent à toutes les cartes et des puissances qui correspondent à tous les ventilateurs ;
sur la base de la valeur maximum de rapport cyclique de ventilateur, déterminer une valeur de bruit cible ; et
sur la base de la puissance système totale et d'un premier coefficient de pondération qui correspond à la puissance système totale, de la valeur de bruit cible et d'un second coefficient de pondération qui correspond à la valeur de bruit cible, déterminer la valeur de paramètre de récompense.

13. Appareil (40) selon la revendication 10, dans lequel :
après que le dispositif de réseau a été mis sous tension pour son démarrage ou après que le dispositif de réseau a fourni une alarme de température, le module de détermination est en outre configuré pour : sur la base d'une valeur de température de chaque carte du dispositif de réseau, déterminer un rapport cyclique de ventilateur qui doit être réglé qui correspond à chaque ventilateur ; dans lequel, lorsque chaque ventilateur est commandé sur la base de la vitesse de rotation qui correspond au rapport cyclique de ventilateur qui doit être réglé qui correspond au ventilateur, il est validé qu'une valeur absolue d'une différence entre la valeur de température de chaque carte et une valeur de température cible est inférieure à un seuil de température ; et dans lequel :
le module de détermination est en outre configuré pour : après que la valeur absolue de la différence entre la valeur de température de chaque carte et la valeur de température cible est inférieure au seuil de température, déterminer que le dispositif de réseau est dans l'état dans lequel il doit être réglé, mettre à jour le rapport cyclique de ventilateur initial qui correspond à chaque ventilateur à l'aide du rapport cyclique de ventilateur qui doit être réglé qui correspond au ventilateur ; et le module de commande est en outre configuré pour, sur la base de la vitesse de rotation qui correspond au rapport cyclique de ventilateur initial qui correspond à chaque ventilateur, commander le ventilateur.

14. Appareil (40) selon la revendication 10, dans lequel, en réponse au fait que le dispositif de réseau est dans l'état stable, le module de traitement est en outre configuré pour :

obtenir des données d'état détecté qui correspondent au dispositif de réseau ;
entrer les données d'état détecté sur un modèle d'action cible appris pour obtenir un rapport cyclique de ventilateur de sortie qui correspond à chaque ventilateur ; dans lequel des ventilateurs différents correspondent à des rapports cycliques de ventilateur de sortie différents ou à un même rapport cyclique de ventilateur de sortie ;
sur la base des valeurs de récompense du dispositif de réseau sous le rapport cyclique de ventilateur de sortie qui correspond à chaque ventilateur, déterminer une première valeur de paramètre de récompense qui correspond aux rapports cycliques de ventilateur de sortie ; sur la base des données de récompense du dispositif de réseau sous le rapport cyclique de ventilateur cible qui correspond à chaque ventilateur, déterminer une seconde valeur de paramètre de récompense qui correspond aux rapports cycliques de ventilateur cibles ; et
si la première valeur de paramètre de récompense est supérieure à la seconde valeur de paramètre de récompense, déterminer que le dispositif de réseau est dans l'état dans lequel il doit être réglé, mettre à jour le rapport cyclique de ventilateur initial qui correspond à chaque ventilateur à l'aide du rapport cyclique de ventilateur de sortie qui correspond au ventilateur, et retourner à la réalisation, sur la base de la séquence cible de la pluralité de ventilateurs, de l'opération consistant à considérer de façon séquentielle chaque ventilateur en tant que ventilateur candidat.

15. Support de stockage lisible de manière automatique, dans lequel le support de stockage lisible de manière automatique stocke des instructions pouvant être exécutées de manière automatique qui peuvent être exécutées par un processeur ; et le processeur est configuré pour exécuter les instructions qui peuvent être exécutées de manière automatique afin de réaliser les étapes du procédé selon l'une quelconque des revendications 1 à 9.

When the network device is in a to-be-adjusted state, an initial fan duty cycle currently used by each fan is determined ⟋ 101

Based on a target sequence of the plurality of fans, each fan is sequentially traversed out as a candidate fan ⟋ 102

Multiple adjustments are performed on the initial fan duty cycle corresponding to the currently-traversed candidate fan to obtain multiple different candidate fan duty cycles; for each candidate fan duty cycle, reward data of the network device under the candidate fan duty cycle is obtained, and based on the reward data, a reward parameter value corresponding to the candidate fan duty cycle is determined; an optimal reward parameter value is selected from the reward parameter values corresponding to the multiple candidate fan duty cycles, and a candidate fan duty cycle corresponding to the optimal reward parameter value is determined as a target fan duty cycle corresponding to the candidate fan ⟋ 103

After the target fan duty cycle corresponding to each fan is obtained, if the network device is in a stable state, based on the rotation speed corresponding to the target fan duty cycle corresponding to each fan, the fan is controlled ⟋ 104

FIG.1

powered startup state
↓

PID algorithm

↓ to-be-adjusted state

Greedy algorithm

↓ stable state

DDPG algorithm

restart Greedy algorithm

FIG.2

The task of the Actor is to find A in order to maximize the output Q

FIG.3

FIG.4

FIG.5

**REFERENCES CITED IN THE DESCRIPTION**

**Patent documents cited in the description**

- US 2022252078 A1